# FASCICULE DE BREVET EUROPEEN

(11) **EP 2 173 029 B1**
(45) Date de publication et mention de la délivrance du brevet: **22.12.2010**
(21) Numéro de dépôt: 08165830.4
(22) Date de dépôt: 03.10.2008
(51) Int. Cl.: H03C 3/09

(54) **Procédé d'auto-calibrage d'un synthétiseur de fréquence à modulation FSK à deux points**
Selbstkalibrierverfahren eines Frequenzgenerators mit Zweipunkt-FSK-Modulation
Method of self-calibrating a frequency synthesiser with FSK modulation at two points

(43) Date de publication de la demande: 07.04.2010
(73) Titulaire: The Swatch Group Research and Development Ltd., 2074 Marin (CH)
(72) Inventeur: Casagrande, Arnaud, 2014 Bôle (CH)
(74) Mandataire: Couillard, Yann Luc Raymond

(56) Documents cités:
- EP-A- 0 961 412
- US-A1- 2003 043 950
- US-A1- 2003 203 724
- US-A1- 2005 046 488
- US-A1- 2006 197 605
- US-B1- 6 515 553

## Description

L'invention concerne un procédé d'auto-calibrage d'un synthétiseur de fréquence à modulation FSK du type à deux points pour la transmission de données. Le synthétiseur de fréquence, notamment basse puissance, comprend une première boucle à verrouillage de phase basse fréquence dans laquelle est placé un oscillateur commandé en tension, et un accès haute fréquence, qui comprend un convertisseur numérique-analogique, relié à l'oscillateur commandé en tension. La première boucle à verrouillage de phase comprend également un oscillateur de référence, un comparateur de phase relié à l'oscillateur de référence, un premier filtre de boucle passe-bas, et un compteur diviseur multi-mode commandé par un modulateur pour fournir au comparateur de phase un signal divisé sur la base d'un signal haute fréquence de sortie du synthétiseur. L'oscillateur commandé en tension est commandé à une première entrée par un premier signal de tension de commande provenant du premier filtre de boucle, et à une seconde entrée par un second signal de tension de commande pour la modulation de données haute fréquence.

L'invention concerne également un synthétiseur de fréquence à modulation FSK du type à deux points pour la mise en oeuvre du procédé d'auto-calibrage.

On définit une modulation de fréquence du type à deux points par l'addition de la contribution d'un chemin haute fréquence avec un convertisseur numérique-analogique et d'un chemin basse fréquence dans une boucle à verrouillage de phase basse fréquence au niveau de l'oscillateur commandé en tension. Lors de transitions d'état haute fréquence, le chemin haute fréquence est primordial, alors que pour des transitions d'état basse fréquence le chemin basse fréquence devient primordial. Toutefois les deux chemins contribuent à la modulation de données en fréquence pour couvrir une largeur de bande déterminée, qui s'étend en haute fréquence de modulation.

Dans le document de brevet EP 0 961 412, il est décrit un synthétiseur de fréquence pour une modulation de fréquence à deux points pour la transmission de données. Ce synthétiseur de fréquence utilise un modulateur du type sigma delta pour la modulation de données en commandant un diviseur variable dans la boucle à verrouillage de phase basse fréquence, et un convertisseur numérique-analogique DAC pour la modulation haute fréquence. Ce convertisseur DAC a un gain variable, qui est réglé par une unité à commande numérique, et est commandé par un signal de commande numérique pour la modulation en fréquence des données. Ce signal de commande numérique est également transmis au modulateur sigma delta pour combiner la modulation de la boucle basse fréquence et celle fournie par le convertisseur DAC.

Dans ce synthétiseur, il est opéré une variation du retard relatif du signal de modulation passant par le convertisseur DAC par rapport à la modulation dans la boucle basse fréquence. Cependant, rien n'est décrit dans ce document concernant l'adaptation du niveau d'amplitude du spectre des données modulées par la boucle à verrouillage de phase basse fréquence et par l'intermédiaire du convertisseur DAC. De ce fait, il peut survenir des interférences non désirées en fonction de la fréquence de transition d'état pour la transmission des données.

Dans le document de brevet US 2003/0043950, il est également décrit un synthétiseur de fréquence à boucle à verrouillage de phase et à modulation de fréquence à deux points. Ce synthétiseur de fréquence comprend en plus d'une boucle à verrouillage de phase basse fréquence et d'un modulateur sigma delta, un convertisseur numérique-analogique DAC dont la sortie agit directement sur l'oscillateur commandé en tension VCO. Les données sont d'une part modulées à une première entrée de l'oscillateur commandé en tension VCO par l'intermédiaire du diviseur multimode commandé par le modulateur, et à une seconde entrée de l'oscillateur VCO par le convertisseur DAC. Grâce à la modulation à deux points, ce synthétiseur de fréquence permet d'éviter l'atténuation des données modulées haute fréquence due à la largeur de bande étroite de la boucle à verrouillage de phase.

Même si le gain du convertisseur DAC peut être ajusté, il n'est pas prévu d'égaliser le niveau d'amplitude du spectre des données modulées dans la boucle basse fréquence et dans le convertisseur numérique-analogique. Ceci peut conduire comme pour le synthétiseur de fréquence précédent à certains problèmes de distorsion lors de la transition d'état pour la modulation des données.

Dans le document de brevet US 2005/0046488, il est décrit un procédé de compensation ou réglage d'un synthétiseur de fréquence à modulation à deux points. Le synthétiseur de fréquence comprend notamment une première boucle à verrouillage de phase PLL passe-bas, ainsi q'une partie haute fréquence de compensation d'amplitude entre un signal de modulation analogique et un signal de modulation numérique pour opérer une modulation de données à deux points.

La première boucle à verrouillage de phase de ce document comprend un détecteur de phase et fréquence, une première pompe de charges, un premier filtre de boucle passe-bas et un oscillateur commandé en tension VCO. L'oscillateur commandé en tension comprend en entrée un additionneur dont une première entrée est reliée au premier filtre passe-bas, suivi d'une unité de génération de fréquence. Un diviseur programmable N-fractionnel referme la première boucle entre l'oscillateur commandé en tension et le détecteur de phase et fréquence, qui reçoit un signal de référence d'un oscillateur de référence. Ce diviseur est commandé par un signal de modulation numérique fourni par un modulateur.

La partie haute fréquence de compensation de ce document comprend également pour former une seconde boucle à verrouillage de phase, une seconde pompe de charges et un second filtre de boucle passe-bas relié par l'intermédiaire d'un interrupteur à une seconde entrée de l'additionneur de l'oscillateur commandé en tension. La seconde pompe de charges et le second filtre passe-bas sont de structure identique à la première pompe de charges et au premier filtre passe-bas. Cette partie haute fréquence comprend encore une unité de comparaison, qui est un comparateur, dont la sortie est reliée à une unité de modulation analogique, qui reçoit un signal de modulation analogique provenant d'un convertisseur numérique-analogique.

Selon le procédé de compensation de ce document, un premier signal de modulation numérique est fourni par le modulateur pour que la première boucle à verrouillage de phase soit adaptée à une première fréquence, qui correspond à la fréquence porteuse sélectionnée du canal de transmission moins une amplitude de modulation numérique. Dans une seconde étape, un second signal de modulation numérique est fourni par le modulateur pour que la seconde boucle à verrouillage de phase soit mise en fonction tout en maintenant une première tension correspondant à la première fréquence sur le premier filtre de la première boucle déconnectée. Avec ce second signal de modulation numérique, une seconde fréquence est synthétisée qui correspond à la fréquence porteuse sélectionnée additionnée à une amplitude de modulation numérique. Comme une addition est opérée par l'additionneur de l'oscillateur commandé en tension, la seconde tension sur le second filtre représente un signal différentiel relatif au double de l'amplitude de modulation analogique. Ce signal différentiel est ainsi comparé avec une tension multipliée par deux fournie en sortie de l'unité de modulation analogique découplée. L'amplitude comparée des signaux est égalisée par le comparateur, qui agit sur l'unité de modulation analogique afin d'adapter l'amplitude du signal de sortie de modulation analogique.

Un des inconvénients du synthétiseur de fréquence à modulation à deux points du document de brevet US 2005/0046488 est qu'il y a un gain comparable entre la première boucle et la seconde boucle. Ceci exige de prévoir une place importante pour chacun des filtres passe-bas de boucle de taille identique sur un circuit intégré réalisé pour un tel synthétiseur. Un autre inconvénient est que l'oscillateur commandé en tension comprend un additionneur en entrée qui permet d'additionner la contribution du chemin haute fréquence avec le chemin basse fréquence du synthétiseur. Les première et seconde tensions de commande de l'oscillateur ne sont donc pas indépendantes l'une de l'autre, mais directement additionnées pour que le résultat de l'addition détermine la fréquence de sortie de l'oscillateur. Ceci ne permet pas d'adapter une sensibilité différente des deux entrées de l'oscillateur commandé en tension. Un autre inconvénient est que ce n'est pas le convertisseur numérique-analogique qui est calibré directement mais une unité de modulation analogique, ce qui complique l'agencement avec le convertisseur dans le circuit intégré du synthétiseur, avec une consommation électrique plus importante, car les deux unités sont toujours en fonction. Une calibration doit en outre être effectuée pour chaque nouvelle fréquence porteuse sélectionnée, ce qui est désavantageux.

L'invention a donc pour but de fournir un procédé d'auto-calibrage d'un synthétiseur de fréquence qui permet d'égaliser facilement le niveau d'amplitude du spectre des données modulées par le convertisseur numérique-analogique combiné avec la première boucle à verrouillage de phase basse fréquence tout en palliant les inconvénients susmentionnés de l'état de la technique. Ceci doit permettre d'éviter d'avoir des distorsions lors de transitions haute fréquence d'état des données à transmettre ou des retards de transition d'état par la boucle basse fréquence, tout en minimisant la taille de certains composants électroniques dans l'accès haute fréquence pour réaliser le synthétiseur, et en réduisant la consommation électrique générale.

A cet effet, l'invention concerne un procédé d'auto-calibrage d'un synthétiseur de fréquence, qui comprend les caractéristiques mentionnées dans la revendication indépendante 1.

Des étapes particulières du procédé d'auto-calibrage sont définies dans les revendications dépendantes 2 à 7.

Un avantage d'un tel procédé d'auto-calibrage selon l'invention réside dans le fait que le convertisseur numérique-analogique peut être automatiquement calibré en ajustant son gain en comparant la tension sur un second filtre de boucle dans l'accès haute fréquence d'une seconde boucle à verrouillage de phase en fonction, et la tension de sortie dudit convertisseur. Ce gain du convertisseur est ajusté après avoir effectué une première phase de verrouillage de la première boucle à verrouillage de phase sur un canal de transmission à fréquence porteuse déterminée, et fourni un premier mot de commande en entrée du convertisseur pour correspondre à cette fréquence porteuse.

Après une seconde phase de verrouillage à une première fréquence de sortie haute de modulation par une seconde boucle, cette seconde boucle est déconnectée dans une troisième phase. Ceci permet de maintenir une tension de calibrage sensiblement constante et sans fluctuations sur le second filtre de boucle. Ainsi, la comparaison de tension dans l'accès haute fréquence est effectuée avantageusement dans cette troisième phase sur la base d'un second mot de commande fourni au convertisseur normalement dans une seconde phase correspondant à la première fréquence de sortie haute de modulation. L'écart de tension en sortie du convertisseur est donc calibré au moyen de la tension de calibrage constante sur le second filtre, pour une déviation de fréquence de modulation identique entre la première boucle à verrouillage de phase et l'accès haute fréquence.

Avantageusement, une quatrième phase, dans laquelle la seconde boucle à verrouillage de phase est fermée et verrouillée à une seconde fréquence de sortie basse de modulation, est suivie par une cinquième phase du procédé d'auto-calibrage, dans laquelle la seconde boucle est déconnectée pour mémoriser une tension basse de calibrage sur le second filtre. Ceci permet de calibrer le convertisseur numérique-analogique sur la base d'une comparaison de la tension mémorisée sur le second filtre de boucle. Pour ce faire, un troisième mot de commande est fourni au convertisseur afin de comparer la tension de sortie dudit convertisseur avec la tension sur le second filtre de boucle pour ajuster à nouveau le gain du convertisseur. La modulation de fréquence pour la transmission de données peut être avantageusement effectuée par commutation entre la première fréquence de sortie et la seconde fréquence de sortie autour de la fréquence porteuse.

Avantageusement, la seconde boucle à verrouillage de phase comprend un second filtre de petite taille par rapport au premier filtre de la première boucle à verrouillage de phase. Ce second filtre de petite taille permet de fournir une seconde tension de commande à une seconde entrée de l'oscillateur commandé en tension, qui a une seconde sensibilité de plusieurs ordres de grandeur inférieure à la première sensibilité de la première entrée de l'oscillateur, par exemple de l'ordre de 100 fois inférieure. Ainsi toute l'opération de calibrage du convertisseur numérique-analogique est effectuée avec un minimum de composants électroniques, qui occupent une place relativement restreinte par rapport aux composants liés à la première boucle à verrouillage de phase.

Avantageusement, la première boucle et/ou la seconde boucle à verrouillage de phase peuvent comprendre une structure différentielle notamment la pompe de charges et le filtre de boucle. Grâce à la structure différentielle, cela permet d'éviter certaines erreurs de tension mémorisée sur le premier et/ou le second filtres de boucle lors d'une déconnexion progressive de la première et/ou la seconde pompes de charges.

L'invention a également pour but de fournir un synthétiseur de fréquence à modulation de fréquence à deux points, qui comprend des moyens pour égaliser le niveau d'amplitude du spectre des données modulées par le convertisseur numérique-analogique combiné avec la première boucle à verrouillage de phase.

A cet effet, l'invention concerne un synthétiseur de fréquence pour la mise en oeuvre du procédé d'auto-calibrage, qui comprend les caractéristiques mentionnées dans la revendication indépendante 8.

Des formes d'exécution avantageuses du synthétiseur de fréquence sont définies dans les revendications dépendantes 9 à 15.

Les buts, avantages et caractéristiques du procédé d'auto-calibrage d'un synthétiseur de fréquence à modulation de fréquence à deux points, et du synthétiseur de fréquence pour sa mise en oeuvre apparaîtront mieux dans la description suivante sur la base d'au moins une forme d'exécution non limitative illustrée par les dessins sur lesquels :
la figure 1 représente de manière simplifiée une forme d'exécution d'un synthétiseur de fréquence pour une modulation de fréquence à deux points selon l'invention,
les figures 2a à 2f représentent les différentes étapes du procédé d'auto-calibrage en montrant clairement les différents éléments en fonction du synthétiseur de fréquence à modulation de fréquence à deux points de la figure 1 pour chaque étape du procédé selon l'invention,
les figures 3a et 3b représentent des graphiques des fonctions de transfert ou du spectre des données modulées par la première boucle à verrouillage de phase basse fréquence et par l'accès haute fréquence du synthétiseur de fréquence à deux points, et
les figures 4a à 4c représentent des graphiques de la modulation de fréquence dans le temps avec des distorsions ou des retards du signal apparaissant lorsque le gain du convertisseur numérique-analogique n'est pas calibré comme montré dans les figures 4a et 4b.

Dans la description suivante, tous les composants du synthétiseur de fréquence à modulation de fréquence (FSK) à deux points, qui sont bien connus d'un homme du métier dans ce domaine technique, ne sont décrits que de manière simplifiée. Il est spécifiquement précisé tous les éléments du synthétiseur de fréquence qui permettent de mettre en oeuvre le procédé d'auto-calibrage pour égaliser le niveau d'amplitude du spectre de données modulées par le synthétiseur de fréquence.

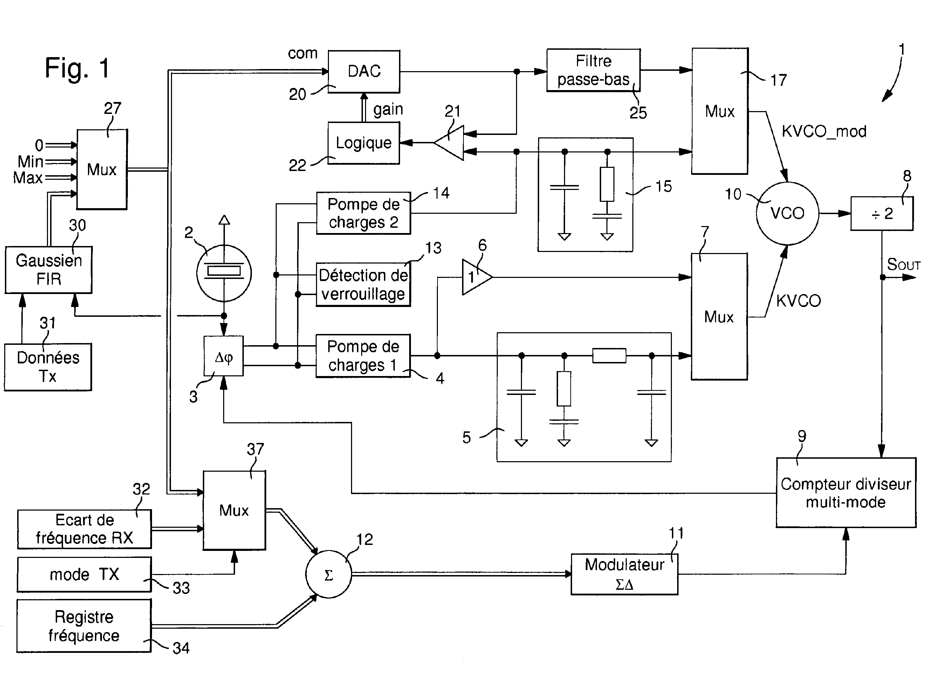

A la figure 1, il est représenté une forme d'exécution préférée d'un synthétiseur de fréquence 1 à modulation de fréquence du type à deux points. Ce synthétiseur de fréquence peut servir notamment pour la transmission de données modulées en fréquence dans un signal radiofréquence. Le synthétiseur de fréquence peut constituer une partie importante d'un transmetteur GFSK travaillant dans une bande de fréquence proche de 2.45 GHz. Ce synthétiseur de fréquence peut être réalisé dans une technologie CMOS à 0.18 µm par exemple.

Le synthétiseur de fréquence 1 comprend principalement une première boucle à verrouillage de phase basse fréquence ou passe-bas, et un accès haute fréquence relié à un oscillateur commandé en tension VCO 10 de la première boucle à verrouillage de phase. L'accès haute fréquence comprend un convertisseur numérique-analogique 20 et des moyens pour calibrer automatiquement le gain du convertisseur comme expliqué ci-dessous. Une précision de fréquence est obtenue par l'intermédiaire de la première boucle à verrouillage de phase basse fréquence, et la rapidité de commutation est obtenue par l'accès haute fréquence. Pour des transitions d'état haute fréquence lors de la modulation de données, l'accès haute fréquence est ainsi principalement utilisé, alors que pour des transitions d'état basse fréquence, la première boucle à verrouillage de phase plus précise est utilisée.

La première boucle à verrouillage de phase basse fréquence comprend tout d'abord un oscillateur de référence 2, qui peut être de préférence un oscillateur à quartz, pour fournir un signal de référence, ayant une fréquence située entre 16 et 26 MHz, à un comparateur de phase 3. Un premier filtre de boucle passe-bas 5 est relié au comparateur de phase par l'intermédiaire d'une première pompe de charges 4, qui constitue une partie de moyens de connexion. Deux fils relient le comparateur de phase 3 à la première pompe de charges pour fournir un signal numérique haut et bas bien connu à la première pompe de charges 4. Le courant de polarisation de cette pompe de charges typique peut être situé au voisinage de 3 µA.

L'oscillateur commandé en tension VCO 10 peut comprendre deux varacteurs dédicacés en parallèle, qui sont indépendants l'un de l'autre. Le premier varacteur de l'oscillateur a une première entrée à grande sensibilité et le second varacteur de l'oscillateur a une seconde entrée à faible sensibilité. La fréquence f(V) de sortie de l'oscillateur est l'addition de la fréquence f1(V1) générée par le premier varacteur et la fréquence f2(V2) générée par le second varacteur. Il est opéré une sommation capacitive par ces deux varacteurs, et non une sommation de tension en entrée comme traditionnellement.

Cet oscillateur commandé en tension est ainsi relié par une première entrée à grande sensibilité du premier varacteur, par exemple de l'ordre de 400 MHz/V dans la première boucle à verrouillage de phase. La première entrée de l'oscillateur commandé en tension peut recevoir un premier signal de tension de commande KVCO par l'intermédiaire du premier filtre de boucle 5. Ce filtre de boucle peut être un filtre passe-bas du deuxième ordre comme montré par l'agencement des trois condensateurs (p. ex. 20 pF, 200 pF, 10 pF) et deux résistances (p. ex. 100 kOhm, 16 kOhm) du bloc du filtre passe-bas 5. La fréquence de coupure de ce premier filtre de boucle peut être choisi à 100 kHz en fonction de la fréquence de l'oscillateur de référence 2.

L'oscillateur commandé en tension 10 est susceptible de générer un signal haute fréquence dont la fréquence peut être voisine de 5 GHz. Cependant la transmission des données modulées du transmetteur GFSK est opérée sur une fréquence porteuse d'un canal de transmission proche de 2.45 GHz. De ce fait, l'oscillateur commandé en tension 10 est suivi dans la première boucle à verrouillage de phase par un diviseur par deux 8 afin de fournir un signal de sortie haute fréquence S_{OUT} comprenant des données modulées à transmettre.

Le signal de sortie haute fréquence S_{OUT} est divisé par un compteur diviseur multi-mode 9 commandé par un modulateur, tel qu'un modulateur sigma delta 11 bien connu. Ce modulateur sigma delta peut être réalisé sur la base d'une structure basique MASH 1-1-1 du troisième ordre. Le compteur diviseur multi-mode 9 fournit un signal divisé par un facteur N-fractionnel au comparateur de phase 3 de la première boucle à verrouillage de phase de manière à être comparé au signal de référence de l'oscillateur de référence 2.

Pour la mise en oeuvre du procédé d'auto-calibrage, la première boucle à verrouillage de phase comprend encore en parallèle du premier filtre de boucle 5, un suiveur de tension unitaire 6, dont l'entrée est reliée entre la sortie de la première pompe de charges 4 et le premier filtre de boucle 5. Un premier multiplexeur 7 reçoit à une première entrée un signal de tension du suiveur de tension unitaire 6 et à une seconde entrée un signal de tension du premier filtre de boucle 5. La sortie du premier multiplexeur est reliée directement à la première entrée de l'oscillateur commandé en tension 10 pour fournir le premier signal de tension de commande KVCO. Le premier signal de tension de commande KVCO provient soit directement du premier filtre de boucle 5, soit directement du suiveur de tension en fonction de l'état d'un signal de commande fourni au premier multiplexeur non représenté.

Comme il sera expliqué par la suite, le suiveur de tension unitaire 6 est utilisé dans le procédé d'auto-calibrage notamment lorsque la première pompe de charges est mise hors fonction. Dans ce cas, le varacteur de l'oscillateur commandé en tension 10 perd un peu de courant, ce qui est compensé par le suiveur de tension, afin que la tension sur le premier filtre de boucle 5 reste constante pour fournir le premier signal de tension de commande KVCO. Cependant une fois l'opération de calibrage terminée, le suiveur de tension unitaire 6 doit être déconnecté pour la modulation des données.

Le retrait du suiveur de tension est nécessaire pour des raisons de stabilité, car la largeur de bande du suiveur doit être au moins 10 fois la fréquence de coupure du premier filtre de boucle, qui est de l'ordre de 100 kHz. De plus, le bruit généré par le suiveur de tension unitaire 6 est converti en bruit de phase, ce qui peut être un problème avec le large gain dans l'oscillateur commandé en tension 10 lié au premier signal de tension de commande KVCO.

La première boucle à verrouillage de phase peut comprendre une structure différentielle non représentée entre la première pompe de charges 4 et l'oscillateur commandé en tension 10. Cette structure peut être composée d'une première pompe de charges différentielle, d'un premier filtre de boucle différentiel 5 et d'un suiveur de tension différentiel à gain unitaire 6. Le premier multiplexeur 7 peut ainsi relier soit la sortie du suiveur de tension différentiel, soit la sortie du premier filtre de boucle à la première entrée différentielle de l'oscillateur commandé en tension. Dans cette structure différentielle, la valeur capacitive du premier filtre de boucle différentiel vaut avantageusement la moitié de la valeur capacitive d'un premier filtre de boucle asymétrique, ce qui réduit sa surface lors d'une intégration.

Grâce à la structure différentielle depuis la première pompe de charges 4 différentielle, la première boucle à verrouillage de phase basse fréquence est ainsi isolée des perturbations pouvant survenir. Ces perturbations peuvent ainsi être annulées, ce qui peut être important du fait de la grande sensibilité (400 MHz/V) à la première entrée de l'oscillateur commandé en tension 10. Ainsi, la fréquence porteuse du canal de transmission sélectionné est générée précisément par l'intermédiaire de la première boucle à verrouillage de phase.

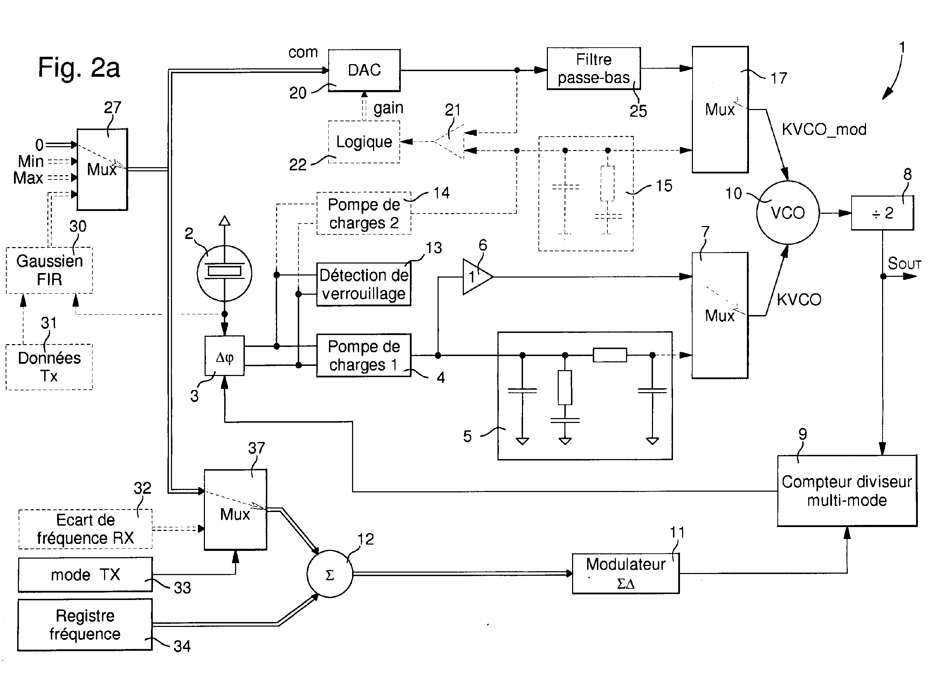

L'accès haute fréquence du synthétiseur de fréquence 1 pour la modulation de fréquence à deux points, comprend donc le convertisseur numérique-analogique. Ce convertisseur numérique-analogique 20 pourrait être implémenté avec des sources de courant commutées et une charge active en poly-résistance OTA. Les sources de courant peuvent par exemple être annulées dans le cas d'un mot de commande com reçu défini comme 0 dans une première phase du procédé d'auto-calibrage. Avec ce mot de commande défini à 0, cela permet au convertisseur de ne pas être influencé par une modification du gain du convertisseur. Ceci peut être avantageux pour les opérations de calibrage dudit convertisseur, qui sont décrites ci-après en référence aux figures 2a à 2f.

Le signal de tension en sortie du convertisseur numérique-analogique est filtré dans un filtre passe-bas 25, qui est un filtre anti-repliement susceptible de supprimer des fréquences images dans le spectre des données modulées autour de n fois la fréquence d'horloge du convertisseur. Cette fréquence d'horloge peut être par exemple identique à la fréquence du signal de référence. Ce filtre passe-bas 25 peut être constitué par une simple structure RC du premier ordre, car un premier filtrage est déjà effectué dans le convertisseur numérique-analogique 20.

Le signal filtré par le filtre passe-bas 25 peut être fourni en tant que second signal de tension de commande KVCO_mod à une seconde entrée du second varacteur de l'oscillateur commandé en tension 10, indépendant du premier varacteur. La sensibilité en tension à la seconde entrée de l'oscillateur commandé en tension, indépendante de la première entrée, peut être de l'ordre de 4 MHz/V, ce qui est 100 fois inférieur à la sensibilité de la première entrée indiquée ci-devant. Ceci permet au convertisseur numérique-analogique 20 de travailler avec une plus grande amplitude, tout en ayant des pointes dues à l'injection d'horloge du convertisseur moins importantes.

Pour produire une tension plate à la caractéristique de déviation de fréquence, le varacteur de modulation de l'oscillateur commandé en tension 10 doit être polarisé autour de son gain maximum de travail. La déviation maximum de +500 kHz à 4.9 GHz mène à une approximation suffisamment linéaire de la tension à la caractéristique de fréquence de l'oscillateur commandé en tension 10 pour une sensibilité dans la marge de 4 MHz/V. Dans ce cas, la déviation positive de tension maximum nécessaire pour générer +500 kHz de déviation de fréquence est dans la marge de 125 mV pour le second signal de tension de commande KVCO_mod.

Il est à noter que le fait d'utiliser un second varacteur de l'oscillateur commandé en tension, qui présente une sensibilité beaucoup plus faible que celle du premier varacteur de la première boucle à verrouillage de phase, permet de maximiser la tension nécessaire ou l'écart de fréquence à réaliser. Cela permet également de minimiser de ce fait l'influence de l'offset du comparateur 21, qui peut être de l'ordre du mV, et du bruit du convertisseur numérique-analogique 20. Cet offset peut même être supprimé avec une double calibration du convertisseur numérique-analogique avec un écart maximal de fréquence de modulation (Δf) dans une troisième phase, et avec un écart minimal de fréquence de modulation (-Δf) dans une cinquième phase de calibration.

Pour pouvoir calibrer automatiquement le gain du convertisseur numérique-analogique 20, l'accès haute fréquence comprend encore des moyens de calibrage, qui sont mis en fonction pendant l'opération d'autocalibrage du convertisseur. Les moyens de calibrage sont constitués par une seconde pompe de charges 14 reliée au comparateur de phase 3, un second filtre de boucle passe-bas 15, un comparateur de tension 21 pour comparer la tension sur le second filtre de boucle 15 avec la tension de sortie du convertisseur 20, et une logique de commande 22 en sortie du comparateur pour adapter le gain du convertisseur. Le courant de polarisation typique de la seconde pompe de charges 14 peut être situé au voisinage de 40 pA.

Le second filtre de boucle 15 peut être constitué par un premier condensateur (p. ex. 1 pF) en parallèle avec une résistance (p. ex. 400 kOhm) et un second condensateur (p. ex. 20 pF). Ce second filtre de boucle est de taille bien inférieure à la taille du premier filtre de boucle, étant donné qu'il fait partie de la seconde boucle à verrouillage de phase pour fournir une tension de commande à une seconde entrée de l'oscillateur commandé en tension de sensibilité bien inférieure à la première entrée. La fréquence de coupure d'un tel second filtre peut être de l'ordre de 77 kHz. Pour le comparateur de tension, son écart ou offset devrait être petit, par exemple plus bas que 1 mV permettant d'avoir une petite erreur ajoutée à la déviation de fréquence correspondante. De plus, il devrait avoir une vitesse de balayage (slew rate en terminologie anglaise) suffisamment haute pour ne pas ralentir la phase de calibrage de la logique du convertisseur numérique-analogique. Une topologie à capacités commutées compensées en offset pourrait être utilisée.

La seconde boucle à verrouillage de phase peut comprendre également une structure différentielle non représentée entre la seconde pompe de charges 14 et l'oscillateur commandé en tension 10. Cette structure peut être composée d'une seconde pompe de charges différentielle et d'un second filtre de boucle différentiel 15. Le second multiplexeur 17 peut ainsi relier la sortie du second filtre de boucle à la seconde entrée différentielle de l'oscillateur commandé en tension lorsque la seconde boucle est verrouillée. Grâce à la structure différentielle, cela évite des erreurs de tension au niveau du second filtre de boucle lors d'une déconnexion progressive d'une second pompe de charges traditionnelle, car la coupure de transistors de type PMOS peut être plus lente ou plus rapide que la coupure de transistors de type NMOS. Dans cette structure différentielle, la valeur capacitive du second filtre de boucle différentiel vaut avantageusement la moitié de la valeur capacitive d'un second filtre de boucle asymétrique, ce qui réduit sa surface lors d'une intégration.

Avec une telle structure différentielle de la seconde pompe de charges et du second filtre de boucle, et de manière à conserver un comparateur 21, une logique de commande 22 et un convertisseur numérique-analogique 20 de structure asymétrique, il peut être avantageux de disposer un dispositif de conversion entre le second filtre de boucle et l'entrée du comparateur 21. Ce dispositif de conversion non représenté permet de convertir la tension différentielle sur le second filtre en une tension absolue à comparer à la tension de sortie du convertisseur numérique-analogique. Ce dispositif de conversion peut être réalisé conventionnellement par l'intermédiaire d'un amplificateur, et quatre résistances de valeur identique reliées aux entrées et à la sortie de l'amplificateur. Deux suiveurs de tension peuvent encore être prévus entre le second filtre de boucle différentiel et les résistances reliées aux entrées de l'amplificateur.

Concernant la logique de commande 22, elle peut fournir un gain défini sur 5 bits. Ceci permet d'avoir tous les gains possibles entre 250 kHz et 750 kHz de déviation maximum, ce qui mènera à 8 kHz d'erreur de déviation maximum tout en assumant que le second signal de tension de commande KVCO_mod est linéaire. L'algorithme de décision pourrait être basé sur la méthode de Newton.

Pour l'auto-calibrage du convertisseur, le second filtre de boucle 15 est relié à la seconde entrée de l'oscillateur commandé en tension 10 par l'intermédiaire d'un second multiplexeur 17. Dans ce cas, aucun signal de tension sur le filtre passe-bas 25 relié à une autre entrée du second multiplexeur 17, n'est transmis comme second signal de tension de commande KVCO_mod à la seconde entrée de l'oscillateur commandé en tension 10. Lors de l'opération d'auto-calibrage, une seconde boucle à verrouillage de phase passe-bas est réalisée avec la seconde pompe de charges 14 en fonction, liée au comparateur de phase 3 par deux fils et le second filtre de boucle 15 relié à la seconde entrée de l'oscillateur commandé en tension. Cette seconde boucle à verrouillage de phase est réalisée de telle manière à avoir une dynamique différente de la première boucle à verrouillage de phase.

La seconde pompe de charges 14 est donc une partie de moyens de connexion tout comme la première pompe de charges 4. L'une ou l'autre pompe de charges peut être mise en fonction quand l'autre est mise hors fonction pour fermer ou ouvrir l'une ou l'autre boucle à verrouillage de phase comme expliqué ci-dessous en référence aux figures 2a à 2f.

Il peut être prévu également un détecteur de verrouillage 13 relié aux deux fils d'entrée des deux pompes de charges 4, 14 afin de détecter le moment où une des deux boucles à verrouillage de phase en fonction s'est verrouillée sur une fréquence programmée. Cependant, il n'est souvent pas très utile d'utiliser un tel détecteur de verrouillage pour plusieurs raisons notamment dans ledit procédé d'auto-calibrage. Le détecteur de verrouillage peut ne pas être utilisé, car il a un temps de réaction qui peut ne pas être souhaité lors de commutation d'une phase à l'autre dans le procédé d'auto-calibrage. Il n'est utile que lors d'un grand changement de canal de transmission où un grand écart de fréquence est constaté. Une fois que la première boucle à verrouillage de phase s'est verrouillée, le déphasage est très faible ce qui peut être également difficile à détecter. De plus, le temps de verrouillage d'une telle boucle à verrouillage de phase est généralement connu, notamment pour le passage d'un canal de transmission à un autre voisin. De ce fait, il peut est préférable de fixer les temps de commutation (déterministes) d'une phase de calibrage à l'autre.

En verrouillant la seconde boucle à verrouillage de phase sur une fréquence correspondant par exemple à la fréquence porteuse sélectionnée additionnée ou soustraite d'une déviation ou d'un écart de fréquence maximal de modulation désiré, il est possible de calibrer le convertisseur numérique-analogique dans une phase subséquente. Pour ce faire après que la seconde boucle à verrouillage de phase s'est verrouillée sur l'une ou l'autre fréquence de sortie de modulation, cette seconde boucle est progressivement déconnectée pour maintenir une tension mémorisée sensiblement constante sur le second filtre de boucle 15. Cette tension sur le second filtre est ensuite comparée à la tension de sortie du convertisseur 20 par le comparateur de tension 21. Cette tension de sortie du convertisseur dépend d'un mot de commande com fourni à l'entrée du convertisseur pour représenter par exemple l'une ou l'autre fréquence de sortie de modulation souhaitée. Le gain du convertisseur peut être ainsi adapté par la logique de commande 22 qui suit le comparateur de manière à rendre la tension de sortie du convertisseur égale à la tension mémorisée sur le second filtre de boucle. Ce gain est adapté par rapport à une tension de sortie de base du convertisseur en fonction d'un mot de commande représentant par exemple la fréquence porteuse désirée en sortie du synthétiseur.

Lors de la programmation d'une fréquence à synthétiser pour le procédé d'auto-calibrage, le modulateur sigma delta 11 reçoit le même mot de commande que le convertisseur numérique-analogique 20. Pour ce faire, un troisième multiplexeur 37 reçoit en entrée soit le mot de commande com, soit un écart de fréquence 32 dans un mode de réception du transmetteur GFSK. Cet écart de fréquence permet d'effectuer une adaptation de la fréquence à synthétiser en fonction de la fréquence de signaux radiofréquences reçus par le transmetteur.

Ce troisième multiplexeur 37 transmet donc dans le mode de modulation commandé par le mode Tx 33, le mot de commande com à un additionneur 12. Cet additionneur permet d'effectuer l'addition d'un mot relatif à la fréquence d'un canal de transmission désiré provenant d'un registre de fréquence 34, et du mot de commande com.

Chaque mot binaire de commande com pour le convertisseur numérique-analogique 20 ou le modulateur sigma delta 11 est préférentiellement de 4 bits. Chaque mot binaire de commande est fourni à travers un multiplexeur 27, défini multiplexeur de modulation. Normalement, les 4 bits du mot binaire de commande pour l'opération de calibrage du convertisseur sont définis entre -8 à +7, mais pour être symétrique par rapport au 0, il n'est choisi que de -7 à 7. Dans ce cas, le mot binaire 0, qui est prévu pour représenter la fréquence porteuse sélectionnée pour le canal de transmission, est 1000. Le mot binaire Max, pour représenter la déviation maximale de fréquence de modulation à additionner à la fréquence porteuse est le mot binaire 1111. Finalement, le mot binaire Min, pour représenter la déviation maximale de fréquence de modulation à soustraire à la fréquence porteuse, est le mot binaire 0001. Cette configuration est définie par le terme anglais N-signed.

Quand le multiplexeur de modulation 27 est commandé par un signal à 2 bits pour fournir le mot binaire 0 au convertisseur numérique-analogique 20, la tension de sortie de base du convertisseur n'est pas influencée par une modification du gain du convertisseur. Par contre, lorsque le multiplexeur de modulation 27 est commandé pour fournir soit le mot binaire Max, soit le mot binaire Min pour l'opération de calibrage du convertisseur, le gain du convertisseur calibré a une influence directe sur le niveau de la tension de sortie du convertisseur numérique-analogique. Ceci permet par comparaison de tension dans le comparateur de tension 21 d'ajuster l'écart de tension en sortie du convertisseur entre la tension de sortie représentant la fréquence porteuse et la tension de sortie représentant l'une ou l'autre des fréquences de sortie de modulation. De cette manière comme expliqué par la suite en référence aux figures 2a à 2f, il est possible d'égaliser la déviation de fréquence dans la première boucle à verrouillage de phase et dans l'accès haute fréquence pour ne pas avoir de distorsions aux changement d'état lors de la modulation des données.

Lorsque le gain du convertisseur numérique-analogique est calibré automatiquement, il est possible de placer le synthétiseur dans un mode de modulation de données. Pour ce faire, le multiplexeur de modulation 27 est commandé pour être relié à un filtre numérique du type gaussien 30 cadencé par un signal d'horloge fourni par le signal de référence de l'oscillateur de référence 2. Le filtre du type gaussien met en forme un signal de données Tx 31 afin de fournir une succession de mots binaires de commande pouvant changer d'état dans le temps à une fréquence pouvant aller jusqu'à 2 MHz par exemple en fonction des données à transmettre. De ce fait, le convertisseur numérique-analogique doit être assez rapide pour suivre le taux maximum du flux de bits de modulation d'au moins 1 Mbit/sec, et qui peut être au maximum de 2 Mbit/sec.

Il est à noter que la fréquence du signal haute fréquence généré par l'oscillateur commandé en tension 10 vaut le double de la fréquence du signal de sortie haute fréquence S_{OUT}, qui comprend des données modulées en fréquence, en sortie d'un diviseur par deux 8. De ce fait, il doit être prévu de programmer le double de la déviation ou écart de fréquence maximal de modulation Δf et de la fréquence porteuse fₒ pour obtenir la fréquence désirée dans le signal de sortie haute fréquence S_{OUT}. La fréquence porteuse d'un canal de transmission sélectionné, dans le signal de sortie S_{OUT}, peut être de valeur proche de 2.45 GHz avec des données modulées en fréquence, autour de cette fréquence porteuse, à une fréquence d'au moins 1 MHz.

Lorsque la déviation de fréquence de modulation par l'accès haute fréquence n'est pas identique à la déviation de fréquence de modulation par la première boucle à verrouillage de phase avant l'opération de calibrage, il s'ensuit certaines distorsions ou retards de commutation sur le signal de sortie du synthétiseur de fréquence. Pour obtenir une déviation de fréquence lors de la modulation presque constante sur toute la marge de fréquence de la largeur de bande de modulation du synthétiseur, il est nécessaire de calibrer le convertisseur numérique-analogique.

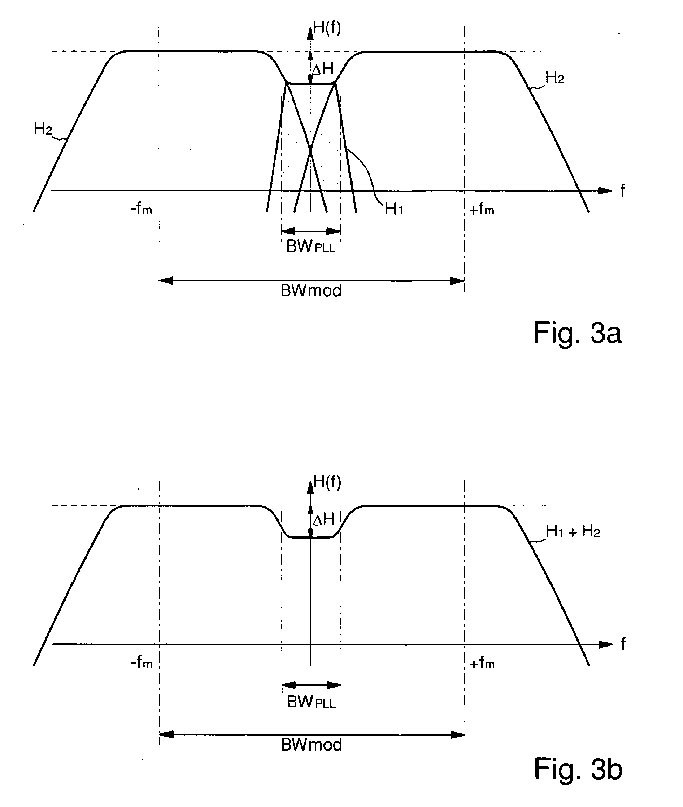

Pour représenter l'écart de déviation de fréquence entre la première boucle à verrouillage de phase et l'accès haute fréquence d'un synthétiseur de fréquence non calibré, il est fait référence aux figures 3a et 3b du spectre des données modulées. Sur ces figures 3a et 3b, il est illustré une première fonction de transfert H₁ de la première boucle à verrouillage de phase et une seconde fonction de transfert H₂ de l'accès haute fréquence. Ces fonctions de transfert peuvent être par exemple exprimées en dB pour la déviation de fréquence divisée par le signal d'entrée. L'amplitude des deux fonctions de transfert doit être égalisée pour calibrer l'accès haute fréquence et la première boucle à verrouillage de phase.

Comme on peut le remarquer par la partie hachurée, la première fonction de transfert H₁ couvre une largeur de bande de modulation basse fréquence (BW_{PLL}) où le premier filtre de boucle à une fréquence de coupure par exemple de l'ordre de 100 kHz. La seconde fonction de transfert H₂ couvre par contre une largeur de bande pouvant aller au-delà de la fréquence maximale de modulation définie par fₘ (1 MHz). Le synthétiseur de fréquence doit être calibré de manière à avoir une largeur de bande de modulation (BW_{mod}) pouvant aller jusqu'à 1 MHz au moins.

L'amplitude maximale de la première fonction de transfert H₁ est représentée inférieure à l'amplitude maximale de la seconde fonction de transfert H₂. Un écart d'amplitude ΔH doit être corrigé de manière à obtenir une amplitude maximale sur toute la largeur de bande de modulation BW_{mod} constante. Une superposition des deux fonctions de transfert est opérée par l'oscillateur commandé en tension où une addition des deux fonctions est effectuée comme montré à la figure 3b.

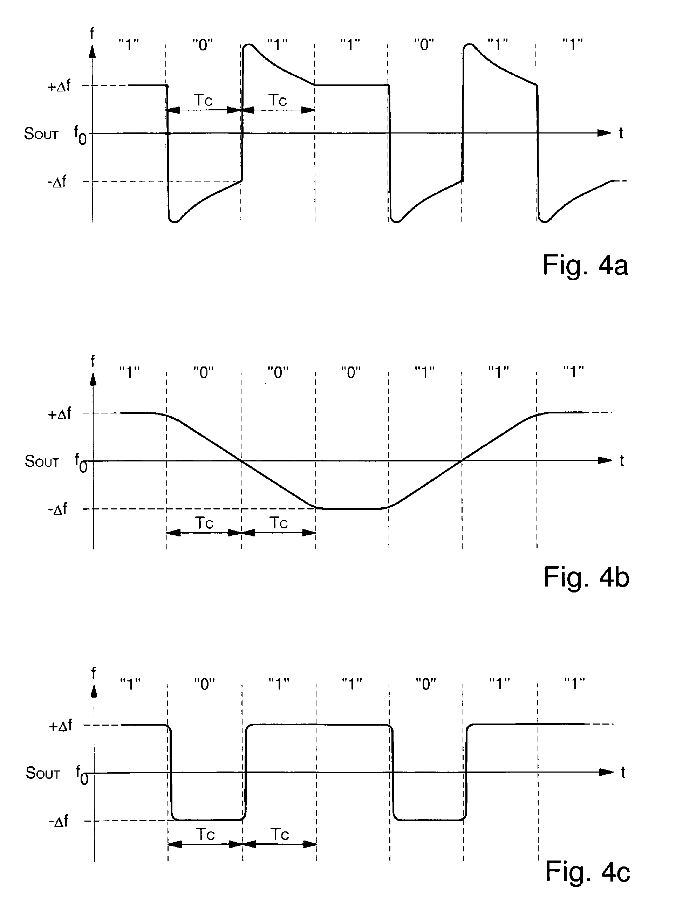

Aux figures 4a à 4c, il est également représenté des graphiques du changement de fréquence dans le temps par rapport à une fréquence porteuse sélectionnée, correspondant à une modulation de données dans le signal de sortie S_{OUT} du synthétiseur de fréquence calibré ou non. Une combinaison de modulation de données par la première boucle à verrouillage de phase et par l'accès haute fréquence est opérée à travers l'oscillateur commandé en tension.

L'état "1" de modulation est défini dans le signal de sortie S_{OUT} par l'addition de la fréquence porteuse fₒ et de la déviation ou l'écart maximal de fréquence de modulation Δf, ce qui donne f₀+Δf. Cet état "1 peut être donné par un mot de commande correspondant au mot Max au convertisseur numérique-analogique et au modulateur sigma delta.

L'état "0" de modulation est défini dans le signal de sortie S_{OUT} par la soustraction de la fréquence porteuse fₒ par la déviation ou l'écart maximal de fréquence de modulation Δf, ce qui donne f₀-Δf. Cet état "0" peut être donné par un mot de commande correspondant au mot Min au convertisseur numérique-analogique et au modulateur sigma delta.

Dans le cas où l'amplitude maximale de la seconde fonction de transfert est plus grande que l'amplitude maximale de la première fonction de transfert comme montré par les figures 3a et 3b, les transitions haute fréquence sont accentuées par rapport aux transitions basse fréquence comme montré à la figure 4a. Il y a donc trop de gain dans le convertisseur numérique-analogique. La fréquence maximale de changement d'état de modulation est défini par 1/Tc.

Dans le cas contraire où l'amplitude maximale de la première boucle à verrouillage de phase est plus grande que celle de l'accès haute fréquence, les transitions d'état sont relativement lentes comme montré à la figure 4b. Il n'y a donc pas assez de gain dans le convertisseur numérique-analogique.

Une fois que le gain du convertisseur numérique-analogique a été calibré comme expliqué ci-après en référence aux figures 2a à 2f, aucune distorsion ou retard de commutation sur le signal de sortie n'est constaté sur toute la largeur de bande de modulation comme montré à la figure 4c.

Bien entendu en lieu et place des figures 4a à 4c, il aurait été possible de représenter un diagramme défini en oeil pour montrer l'état non calibré entre la première boucle et l'accès haute fréquence avec le convertisseur numérique-analogique. Un calibrage effectué montrerait une maximisation de l'ouverture de l'oeil, alors qu'un non calibrage selon la figure 4a ou 4b montrerait une forme d'oeil aplatie selon l'un ou l'autre des axes du diagramme.

En référence aux figures 2a à 2f" il est expliqué toutes les phases ou étapes du procédé d'auto-calibrage du synthétiseur de fréquence 1 de manière à égaliser le niveau d'amplitude du spectre des données modulées par le convertisseur numérique-analogique 20 combiné avec la première boucle à verrouillage de phase basse fréquence. Il est à noter que sur chacune de ces figures, les différentes parties du synthétiseur, qui sont soit au repos, soit mises hors fonction sont représentées en traits interrompus. De cette manière, il est plus facile de comprendre les différentes phases pour le calibrage automatique du convertisseur numérique-analogique, jusqu'à la phase de modulation des données proprement dite. Comme tous les éléments du synthétiseur de fréquence 1 ont été déjà décrits en référence à la figure 1, ils ne seront donc plus explicités en détail.

A la figure 2a, il est représenté la première phase ou étape du procédé d'auto-calibrage du synthétiseur de fréquence 1. Dans cette première phase, la première boucle à verrouillage de phase doit être verrouillée à la fréquence porteuse f₀ d'un canal de transmission sélectionné.

Le multiplexeur de modulation 27 est commandé pour fournir le mot binaire de commande 0 pour représenter la fréquence porteuse fₒ. Ce mot binaire 0 est fourni au convertisseur numérique-analogique 20, ainsi qu'au modulateur sigma delta 11 par l'intermédiaire du multiplexeur 37 et l'additionneur 12. Le modulateur sigma delta reçoit également un mot de fréquence provenant d'un registre de fréquence 34 pour pouvoir définir la fréquence porteuse fₒ à synthétiser par la première boucle à verrouillage de phase.

Dans cette première phase, la première pompe de charges 4 est en fonction, alors que la seconde pompe de charges 14 est déconnectée. De plus, le premier multiplexeur 7 est commandé pour relier la sortie du suiveur de tension unitaire 6 à la première entrée du varacteur principal de l'oscillateur commandé en tension. De cette manière, la tension mémorisée sur le premier filtre de boucle 5 est transmise à travers le suiveur de tension 6 pour fournir le premier signal de tension de commande KVCO.

Le second multiplexeur 17 est commandé pour relier la sortie du filtre anti-repliement passe-bas 25 à la seconde entrée de modulation de l'oscillateur commandé en tension 10. Le convertisseur numérique-analogique 20 fournit donc à travers le filtre passe-bas et le second multiplexeur 17 le second signal de tension de commande dont le niveau est fonction du mot de commande com, qui est dans ce cas le mot binaire 0. Avec ce mot binaire 0, le niveau de cette première tension de sortie de base dudit convertisseur ne change pas avec un changement du gain dudit convertisseur.

En guise de rappel étant donné la fréquence de coupure basse de la première boucle à verrouillage de phase, une modulation en fréquence de données par exemple à 1 ou 2 Mbit/sec ne peut être effectuée par la première boucle basse fréquence. Ceci est dû également au fait que la fréquence de référence de l'oscillateur de référence se situe entre 16 et 26 MHz, et qu'il serait nécessaire d'avoir plutôt une fréquence de l'ordre de 150 MHz pour avoir une boucle suffisamment rapide. Toutefois avec une fréquence de référence à 150 MHz, il n'est pas possible de réduire la consommation électrique du synthétiseur de fréquence, alors que la réduction de consommation peut être escomptée.

Si la fréquence de coupure est fixée aussi basse dans cette boucle à verrouillage de phase basse fréquence, c'est principalement dû au bruit généré par le modulateur sigma delta, qu'il faut supprimer. Cependant avec une fréquence de coupure de l'ordre de 100 kHz, le synthétiseur de fréquence est approximativement 10 fois trop lent avec la fréquence de référence à 16 MHz.

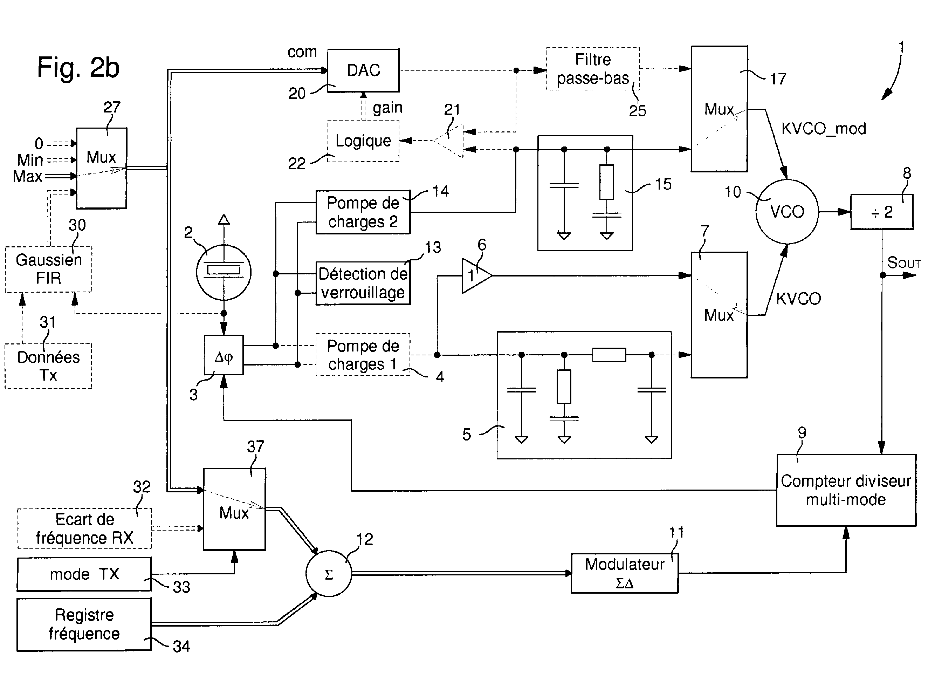

Si on souhaite moduler des données en fréquence à une fréquence de 1 MHz sur le signal de sortie S_{OUT}, il est nécessaire d'augmenter la largeur de bande à 1 MHz à la suite de la première pompe de charges. Cette rapidité de la boucle basse fréquence n'est pas escomptée avec un quartz de l'oscillateur à fréquence si basse. Pour les transitions haute fréquence, il est donc utilisé en plus l'accès haute fréquence pour l'oscillateur commandé en tension. La différence de fréquence pour la modulation de fréquence est asservie par la première boucle à verrouillage de phase, où un petit écart de tension conduit à une grande différence de fréquence. Il faut donc donner un gain précis au convertisseur numérique-analogique afin d'égaliser le niveau d'amplitude du spectre de données modulées dans le première boucle et par l'accès haute fréquence, ce qui est décrit ci-dessous en référence notamment aux figures 2b à 2e.

Grâce à l'accès haute fréquence par l'intermédiaire du convertisseur numérique-analogique, ledit convertisseur va pouvoir injecter les fortes transitions d'état dans la modulation de fréquence en combinaison de la première boucle basse fréquence plus précise. S'il y a un rapide passage d'un état à l'autre des données modulées, il n'y a aucune distorsion ou retard constaté sur le signal de sortie, par le convertisseur numérique-analogique s'il est calibré, ce qui est souhaité.

Une détection du verrouillage par un détecteur de verrouillage 13 peut permettre de déterminer l'instant où la première boucle à verrouillage de phase s'est verrouillée à la fréquence porteuse sélectionnée. Une fois détectée, il peut être passé à la seconde phase du procédé d'autocalibrage représentée à la figure 2b. Cependant comme indiqué précédemment, le temps de verrouillage d'une telle boucle à verrouillage de phase est en général connu et peut être fixé ou programmé pour le passage automatique de la première phase à la seconde phase du procédé d'auto-calibrage.

A la figure 2b, il est représenté la seconde phase ou étape du procédé d'auto-calibrage du synthétiseur de fréquence 1. Dans cette seconde phase, la première pompe de charges 4 doit être déconnectée pour ouvrir la première boucle à verrouillage de phase, alors que la seconde pompe de charges 14 doit être mise en fonction pour former avec le second filtre de boucle 15 une seconde boucle à verrouillage de phase. Dans cette seconde phase, le comparateur 21 et la logique de commande 22 peuvent être déconnectés.

Il faut également prendre garde, dans la seconde phase du procédé, de ne pas déconnecter brutalement la première pompe de charges 4, car il peut subsister une légère erreur de tension constante mémorisée sur le premier filtre de boucle 5, ce qui peut conduire à une erreur de calibrage du convertisseur numérique-analogique par la suite. De ce fait, il serait préférable de couper progressivement la première pompe de charges pour éviter de telles erreurs. Il faut environ 60 cycles avant son extinction. Ainsi, la largeur de bande de la première boucle à verrouillage de phase est progressivement et continûment réduite à 0 Hz pour se trouver dans un régime quasi-stationnaire.

Dans cette seconde phase, la tension mémorisée sur le premier filtre de boucle 5 représentant la fréquence porteuse sélectionnée, est transmise par l'intermédiaire du suiveur de tension unitaire 6 et du premier multiplexeur 7 en tant que premier signal de tension de commande KVCO à la première entrée de l'oscillateur commandé en tension. Cette tension mémorisée représente le premier signal de tension de commande KVCO. Comme indiqué précédemment, le suiveur de tension permet de compenser la perte de courant de l'oscillateur commandé en tension de manière à conserver une tension constante sur le premier filtre de boucle 5.

Le second multiplexeur 17 est commandé pour relier le second filtre de boucle 15 à la seconde entrée de l'oscillateur commandé en tension pour fermer une seconde boucle à verrouillage de phase. Cette seconde boucle à verrouillage de phase doit être verrouillée dans cette seconde phase à une première fréquence de sortie du synthétiseur f₀+Δf, qui doit correspondre à l'addition de la fréquence porteuse f₀ à une déviation ou un écart de fréquence maximal de modulation Δf. La durée de l'opération de verrouillage de la seconde boucle peut être de l'ordre de 40 µs. Pour ce faire, le multiplexeur de modulation 27 doit être commandé pour fournir le mot binaire Max au convertisseur numérique-analogique 20, laissé au repos dans cette seconde phase, et surtout au modulateur sigma delta 11.

La tension mémorisée sur le second filtre de boucle 15 est fournie en tant que troisième signal de tension de commande à la seconde entrée de l'oscillateur commandé en tension 10, qui est à un second niveau de tension. Cette tension mémorisée sur le second filtre 15 va permettre dans la troisième phase, de calibrer automatiquement le convertisseur numérique-analogique 20.

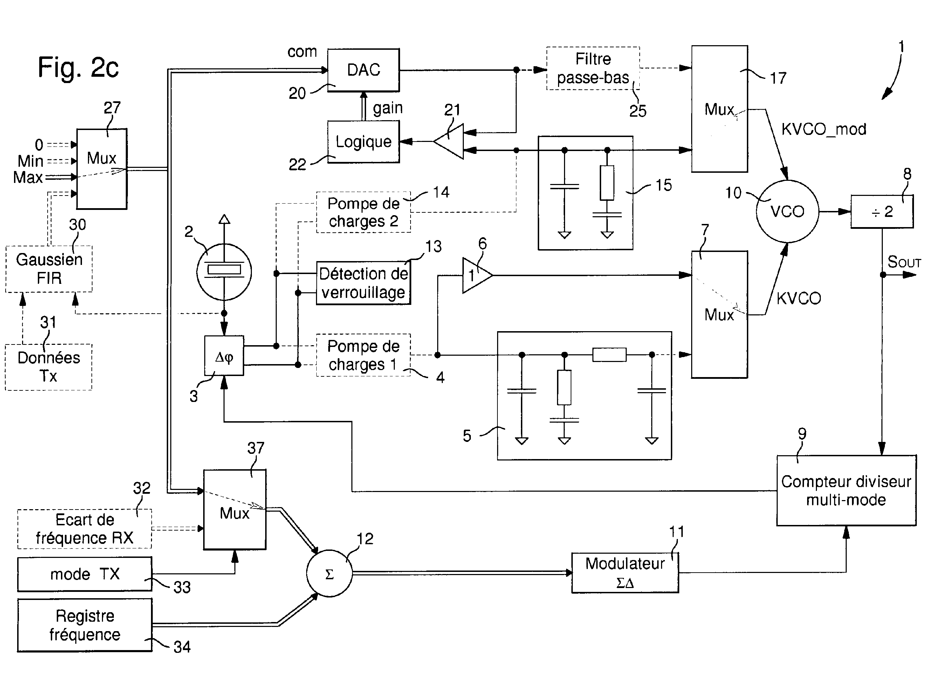

A la figure 2c, il est représenté la troisième phase ou étape du procédé d'auto-calibrage du synthétiseur de fréquence 1. Dans cette troisième phase, la première pompe de charges 4 reste déconnectée, et la seconde pompe de charges 14 est déconnectée tout en maintenant une tension de calibrage mémorisée sur le second filtre de boucle 15. Cette tension de calibrage sur le second filtre de boucle reste sensiblement constante durant toute l'étape de calibrage du convertisseur même si un faible courant de fuite peut être constaté en liaison à la seconde entrée de l'oscillateur commandé en tension 10. La durée de calibrage peut être de l'ordre de 4 µs, ce qui est 10 fois inférieure à la durée de verrouillage de la seconde boucle.

Dans cette troisième phase, le comparateur 21, la logique de commande 22 et le convertisseur numérique-analogique sont en fonction. Ainsi, le comparateur de tension 21 en fonction compare la tension de sortie du convertisseur 20, qui a reçu le mot binaire Max, avec la tension mémorisée sur le second filtre de boucle 15. Le comparateur de tension 21 agit sur une logique de commande 22. Cette logique de commande fournit un mot binaire gain qui permet de calibrer le gain du convertisseur jusqu'à ce que la tension de sortie du convertisseur 20 soit identique à la tension mémorisée sur le second filtre de boucle 15 à un second niveau de tension.

Lors de l'opération de calibrage du convertisseur numérique-analogique plusieurs sauts de tension en sortie du convertisseur sont constatés dû au changement du mot binaire gain, qui adapte le gain dudit convertisseur. Il peut y avoir par exemple 5 mesures effectuées par l'intermédiaire du comparateur 21 et la logique de commande 22 avant d'avoir le gain escompté du convertisseur 20. Il peut être utilisé pour cela un algorithme d'adaptation par dichotomie.

L'écart en tension entre le premier niveau de tension et le second niveau de tension en sortie du convertisseur numérique-analogique 20 est représentatif de la déviation ou écart de fréquence maximal de modulation Δf à calibrer par rapport à la première boucle à verrouillage de phase.

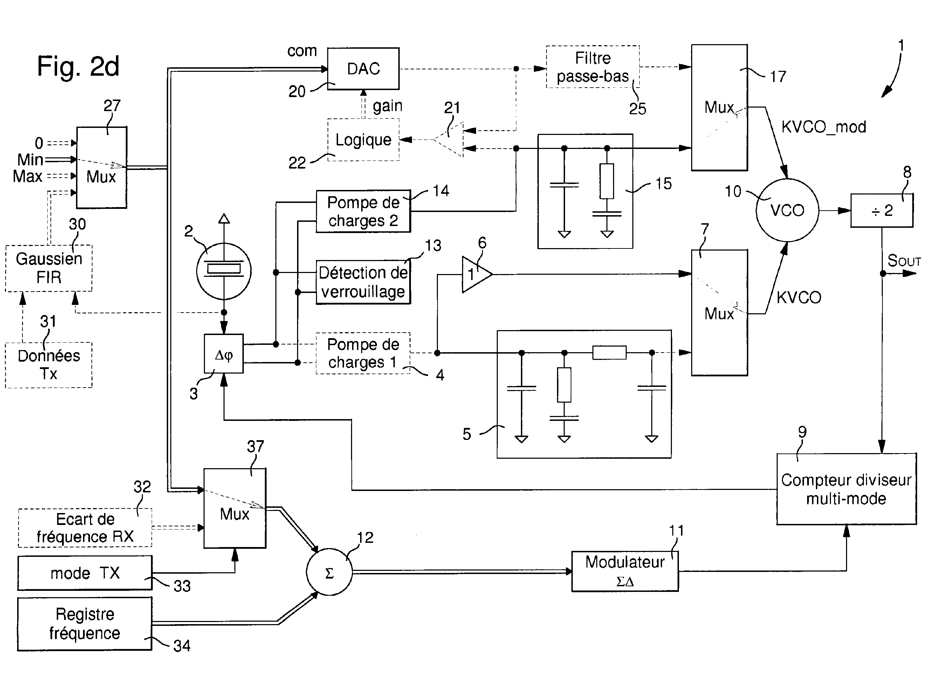

A la figure 2d, il est représenté la quatrième phase ou étape du procédé d'auto-calibrage du synthétiseur de fréquence 1. Cette quatrième phase n'est pas forcément nécessaire pour l'opération de calibrage du synthétiseur de fréquence. Cependant, cette quatrième phase permet de mieux linéariser le synthétiseur de fréquence. Dans cette quatrième phase, le comparateur 21 et la logique de commande 22 peuvent également être déconnectés.

Dans cette quatrième phase, la première pompe de charges 4 reste déconnectée laissant ouverte la première boucle à verrouillage de phase, alors que la seconde pompe de charges 14 est à nouveau remise en fonction pour former avec le second filtre de boucle 15 la seconde boucle à verrouillage de phase. Cette seconde boucle à verrouillage de phase doit être verrouillée cette fois à une seconde fréquence de sortie du synthétiseur f₀-Δf, qui doit correspondre à la soustraction de la fréquence porteuse f₀ par une déviation ou un écart de fréquence maximal de modulation Δf. Pour ce faire, le multiplexeur de modulation 27 doit être commandé pour fournir le mot binaire Min au convertisseur numérique-analogique 20, laissé au repos dans cette quatrième phase, et surtout au modulateur sigma delta 11. Ainsi, la nouvelle tension mémorisée sur le second filtre de boucle 15 est cette fois à un troisième niveau de tension.

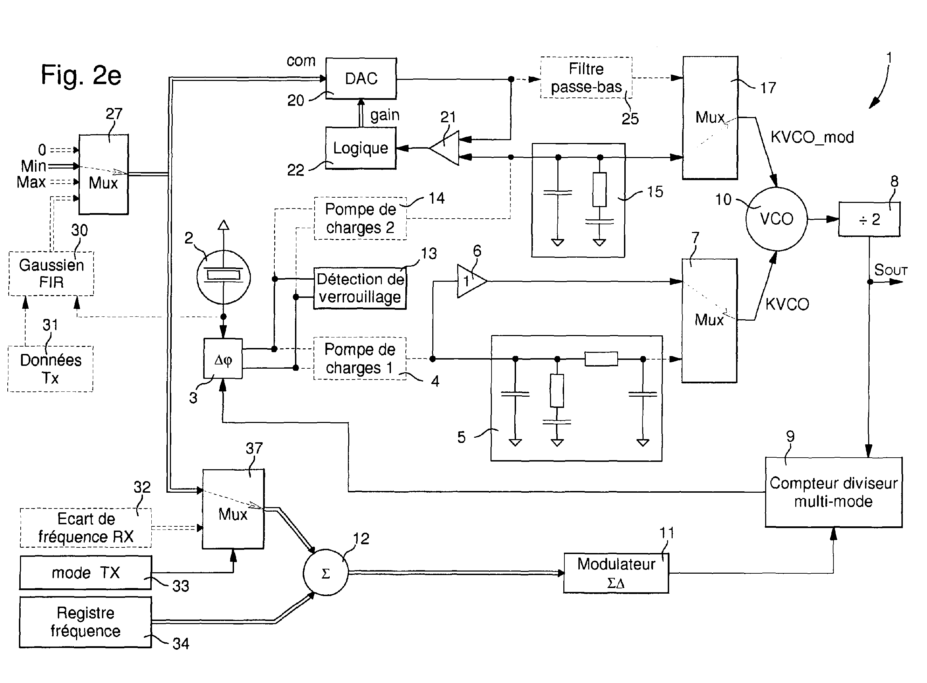

A la figure 2e, il est représenté la cinquième phase ou étape du procédé d'auto-calibrage du synthétiseur de fréquence 1. Dans cette cinquième phase, la première pompe de charges 4 reste déconnectée, et la seconde pompe de charges 14 est à nouveau déconnectée tout en maintenant une nouvelle tension de calibrage mémorisée sur le second filtre de boucle 15 à un troisième niveau de tension. Cette tension de calibrage sur le second filtre de boucle reste sensiblement constante durant toute l'étape de calibrage du convertisseur même si un faible courant de fuite peut être constaté en liaison à la seconde entrée de l'oscillateur commandé en tension 10.

Dans cette cinquième phase, le comparateur 21, la logique de commande 22 et le convertisseur numérique-analogique 20 sont en fonction. Ainsi, cette tension mémorisée sur le second filtre 15 est comparée dans le comparateur de tension 21 à la tension de sortie du convertisseur numérique-analogique, qui a reçu le mot binaire Min. La sortie du comparateur de tension 21 agit sur la logique de commande 22 pour adapter le gain du convertisseur 20 afin de rendre identique la tension de sortie du convertisseur et la tension mémorisée sur le second filtre de boucle 15. Cette nouvelle adaptation du gain du convertisseur peut permettre de supprimer certains défauts de non linéarité dans le synthétiseur de fréquence.

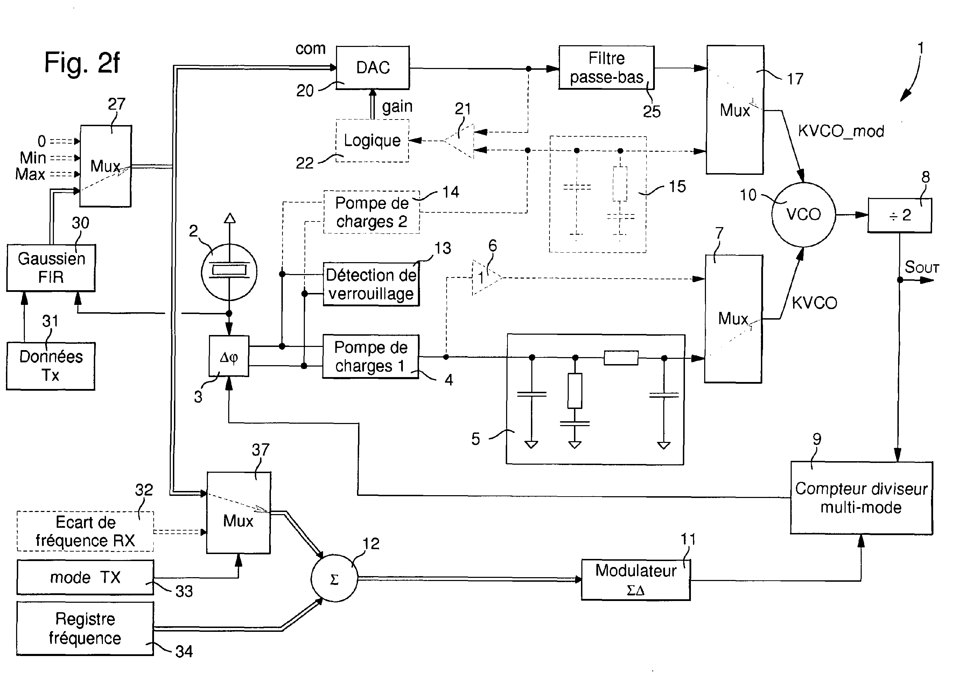

Finalement à la figure 2f, il est représenté une phase de modulation au terme du procédé d'auto-calibrage du synthétiseur de fréquence 1 dès que ledit synthétiseur de fréquence est calibré.

Dans cette phase de modulation, la seconde pompe de charges 14 est déconnectée, et la première pompe de charges 4 est de nouveau remise en fonction. Toutefois, dans cette phase de modulation, le suiveur de tension unitaire 6 doit être déconnecté. De ce fait, le premier multiplexeur 7 est commandé pour relier directement le premier filtre de boucle 5 à la première entrée de l'oscillateur commandé en tension 10.

Du côté de l'accès haute fréquence, le second multiplexeur 17 est commandé pour relier le filtre passe-bas anti-repliement 25 directement à la seconde entrée de l'oscillateur commandé en tension 10. Un second signal de tension de commande KVCO_mod peut être fourni par le convertisseur numérique-analogique 20.

Le multiplexeur de modulation 27 est commandé cette fois pour fournir en sortie une succession de mots de commande provenant du filtre numérique du type gaussien 30 sur la base de données Tx 31 à moduler dans le signal de sortie haute fréquence S_{OUT}. Cette succession de mots de commande est fournie aussi bien au convertisseur 20, qu'au modulateur sigma delta 11 par l'intermédiaire du multiplexeur 37 et de l'additionneur 12. Comme le gain du convertisseur 20 est calibré, la combinaison de la première boucle à verrouillage de phase avec l'accès haute fréquence permet d'obtenir un signal de sortie haute fréquence sans aucune distorsion ou retard de commutation de la modulation de données.

A partir de la description qui vient d'être faite, plusieurs variantes du procédé d'auto-calibrage du synthétiseur et du synthétiseur pour sa mise en oeuvre peuvent être conçues par l'homme du métier sans sortir du cadre de l'invention définie par les revendications. Dans les moyens de connexion, les pompes de charges pourraient être remplacées par des interrupteurs, mais la structure d'une pompe de charges est relativement plus simple et plus rapide qu'une structure d'interrupteur. La sensibilité aux deux entrées de l'oscillateur commandé en tension peut être modifiée. Il peut être prévu deux ou plusieurs convertisseurs numériques-analogiques à calibrer et à relier à une seconde entrée de l'oscillateur commandé en tension. La fréquence de l'oscillateur de référence peut être modifiée ou adaptée. Finalement, l'oscillateur commandé en tension peut générer en sortie deux signaux haute fréquence en opposition de phase.

## Revendications

1. Procédé d'auto-calibrage d'un synthétiseur de fréquence (1) susceptible d'opérer une modulation de fréquence à deux points pour la transmission de données, le synthétiseur de fréquence comprenant :
- une première boucle à verrouillage de phase basse fréquence dans laquelle sont placés un oscillateur de référence (2), un comparateur de phase (3) relié à l'oscillateur de référence, un premier filtre de boucle passe-bas (5), un oscillateur commandé en tension (10), qui est relié par une première entrée d'un premier varacteur d'une première sensibilité dans la première boucle basse fréquence pour recevoir un premier signal de tension de commande (KVCO) par l'intermédiaire du premier filtre passe-bas, un compteur diviseur multi-mode (9) commandé par un modulateur (11) pour diviser en fréquence un signal de sortie haute fréquence (S_{OUT}) sur la base d'un signal haute fréquence produit par l'oscillateur commandé en tension, afin de fournir un signal divisé à comparer à un signal de référence de l'oscillateur de référence dans le comparateur de phase, et
- un accès haute fréquence dans lequel est placé un convertisseur numérique-analogique (20) pour fournir un second signal de tension de commande (KVCO_mod) à une seconde entrée d'un second varacteur_d'une seconde sensibilité de l'oscillateur commandé en tension (10) pour la modulation de données haute fréquence, la seconde sensibilité étant de plusieurs ordres de grandeur inférieure à la première sensibilité, et le second varacteur étant indépendant du premier varacteur,
le procédé d'auto-calibrage comprenant les étapes de :
a) dans une première phase, verrouiller la première boucle à verrouillage de phase passe-bas sur un canal de transmission à fréquence porteuse déterminée (fₒ) en sortie du synthétiseur, et fournir un premier mot de commande (0, com) au convertisseur dans l'accès haute fréquence correspondant à la fréquence porteuse déterminée pour générer un second signal de tension de commande pour l'oscillateur commandé en tension, à un premier niveau de tension de base,
b) dans une seconde phase, ouvrir la première boucle à verrouillage de phase tout en maintenant par le premier filtre de boucle un premier signal de tension de commande correspondant à la fréquence porteuse déterminée pour la première entrée de l'oscillateur commandé en tension, verrouiller une seconde boucle à verrouillage de phase, qui comprend un second filtre de boucle passe-bas (15) dans l'accès haute fréquence relié entre le comparateur de phase (3) de la première boucle et la seconde entrée de l'oscillateur commandé en tension, à une première fréquence de sortie (f₀+Δf) égale à la fréquence porteuse additionnée à un écart de fréquence maximal de modulation, et fournir au convertisseur numérique-analogique un second mot de commande (Max, com) pour représenter la première fréquence de sortie (f₀+Δf),
c) dans une troisième phase, ouvrir la seconde boucle à verrouillage de phase tout en maintenant par le second filtre de boucle un second signal de tension de commande correspondant à la première fréquence de sortie (f₀+Δf) pour la seconde entrée de l'oscillateur commandé en tension, et comparer une tension de sortie provenant directement du convertisseur avec la tension mémorisée sur le second filtre de boucle pour calibrer automatiquement le gain du convertisseur afin que la tension de sortie du convertisseur soit équivalente à la tension mémorisée sur le second filtre à un second niveau de tension, dont l'écart avec le premier niveau de tension de base définit l'écart de fréquence maximal de modulation égalisé, et
d) dans une phase de modulation, fermer la première boucle à verrouillage de phase et relier la sortie du convertisseur à la seconde entrée de l'oscillateur commandé en tension pour la modulation de données à deux points par l'oscillateur commandé en tension à l'aide d'une succession dans le temps de mots de commande (30, 31) fournie au convertisseur numérique-analogique calibré et au modulateur de la première boucle à verrouillage de phase.

2. Procédé d'auto-calibrage selon la revendication 1, **caractérisé en ce qu'**il comprend entre l'étape c) et l'étape d), les étapes de :
- dans une quatrième phase, fermer et verrouiller la seconde boucle à verrouillage de phase sur une seconde fréquence de sortie (f₀-Δf) égale à la soustraction de la fréquence porteuse par l'écart de fréquence maximal de modulation, et fournir un troisième mot de commande (Min, com) au convertisseur numérique-analogique (20) pour représenter la seconde fréquence de sortie, et
- dans une cinquième phase, ouvrir la seconde boucle à verrouillage de phase tout en maintenant par le second filtre de boucle un second signal de tension de commande correspondant à la seconde fréquence de sortie (f₀-Δf) pour la seconde entrée de l'oscillateur commandé en tension, et comparer la tension de sortie du convertisseur à la tension mémorisée sur le second filtre de boucle pour calibrer automatiquement le gain du convertisseur afin que la tension de sortie du convertisseur soit équivalente à la tension mémorisée sur le second filtre à un troisième niveau de tension, dont l'écart avec le premier niveau de tension de base définit l'écart de fréquence maximal de modulation égalisé.

3. Procédé d'auto-calibrage selon l'une des revendications précédentes, pour lequel la première boucle à verrouillage de phase comprend une première pompe de charges (4) entre le comparateur de phase (3) et le premier filtre de boucle (5), et la seconde boucle à verrouillage de phase comprend une seconde pompe de charges (14) entre le comparateur de phase (3) et le second filtre de boucle (15), **caractérisé en ce que** l'ouverture ou la fermeture de la première boucle à verrouillage de phase est réalisée par l'intermédiaire de la première pompe de charges, **en ce que** l'ouverture ou la fermeture de la seconde boucle à verrouillage de phase est réalisée par l'intermédiaire de la seconde pompe de charges, et **en ce que** lors d'une phase d'ouverture, la première pompe de charges et/ou la seconde pompe de charges sont progressivement déconnectées, notamment après 60 cycles, où la largeur de bande de la première et/ou de la seconde boucle à verrouillage de phase sont progressivement et continûment réduites à 0 Hz, pour maintenir une tension constante sur le premier filtre et/ou le second filtre à un niveau bien déterminé.

4. Procédé d'auto-calibrage selon l'une des revendications précédentes, **caractérisé en ce que** dans les première à cinquième phases, le premier signal de tension de commande est fourni par un suiveur de tension unitaire (6) relié en entrée au premier filtre de boucle pour compenser la fuite de courant au niveau du premier varacteur de l'oscillateur commandé en tension.

5. Procédé d'auto-calibrage selon la revendication 4, pour lequel un premier multiplexeur (7) est disposé entre la première entrée de l'oscillateur commandé en tension (10) et la sortie du premier filtre de boucle (5) et du suiveur de tension unitaire (6), **caractérisé en ce que** dans les première à cinquième phases, le premier multiplexeur (7) est commandé pour relier le suiveur de tension à la première entrée de l'oscillateur commandé en tension, alors que dans la phase de modulation, le premier multiplexeur est commandé pour relier le premier filtre passe-bas à la première entrée de l'oscillateur commandé en tension.

6. Procédé d'auto-calibrage selon l'une des revendications précédentes, pour lequel un second multiplexeur (17) est disposé entre la seconde entrée de l'oscillateur commandé en tension et une sortie du second filtre de boucle (15) et d'un filtre passe-bas anti-repliement (25) relié au convertisseur numérique-analogique (20), **caractérisé en ce que** dans la première phase et la phase de modulation, le second multiplexeur (17) est commandé pour relier la seconde entrée de l'oscillateur commandé en tension au filtre anti-repliement (25) pour la fourniture directe du second signal de tension de commande provenant de la sortie du convertisseur numérique-analogique (20), et **en ce que** dans les deuxième à cinquième phases, le second multiplexeur est commandé pour relier la seconde entrée de l'oscillateur commandé en tension au second filtre de boucle pour recevoir un troisième signal de tension de commande.

7. Procédé d'auto-calibrage selon l'une des revendications précédentes, **caractérisé en ce que** les étapes de calibrage du convertisseur numérique-analogique sont effectuées dès la mise en fonction du synthétiseur ou dans un mode de fonctionnement du synthétiseur au terme de chaque période de fonctionnement programmée, et **en ce qu'**une logique de commande (22) reliée en sortie d'un comparateur (21) adapte le gain du convertisseur par un mot binaire, tel qu'un mot de 5 bits.

8. Synthétiseur de fréquence (1) pour la mise en oeuvre du procédé d'auto-calibrage selon l'une des revendications précédentes, le synthétiseur de fréquence étant susceptible d'opérer une modulation de fréquence à deux points pour la transmission de données, ledit synthétiseur de fréquence comprenant :
- une première boucle à verrouillage de phase basse fréquence dans laquelle sont placés un oscillateur de référence (2), un comparateur de phase (3) relié à l'oscillateur de référence, un premier filtre de boucle passe-bas (5) relié au comparateur de phase par l'intermédiaire d'une première pompe de charges (4), un oscillateur commandé en tension (10), qui est relié par une première entrée d'un premier varacteur d'une première sensibilité dans la première boucle basse fréquence pour recevoir un premier signal de tension de commande (KVCO) par l'intermédiaire du premier filtre passe-bas, un compteur diviseur multi-mode (9) commandé par un modulateur (11) pour diviser en fréquence un signal de sortie haute fréquence (S_{OUT}) sur la base d'un signal haute fréquence produit par l'oscillateur commandé en tension, afin de fournir un signal divisé à comparer à un signal de référence de l'oscillateur de référence dans le comparateur de phase, et
- un accès haute fréquence dans lequel est placé un convertisseur numérique-analogique (20) pour fournir un second signal de tension de commande (KVCO_mod) à une seconde entrée d'un second varacteur d'une seconde sensibilité de l'oscillateur commandé en tension (10) pour la modulation de données haute fréquence, la seconde sensibilité étant de plusieurs ordres de grandeur inférieure à la première sensibilité, et le second varacteur étant indépendant du premier varacteur,
le synthétiseur de fréquence comprenant un second filtre de boucle (15) dans l'accès haute fréquence susceptible d'être relié par l'intermédiaire d'une seconde pompe de charges (14) entre le comparateur de phase (3) de la première boucle et la seconde entrée de l'oscillateur commandé en tension (10) afin de constituer une seconde boucle à verrouillage de phase basse fréquence pour une opération de calibrage du convertisseur numérique-analogique, et en ce que l'accès haute fréquence comprend un comparateur de tension (21) pour comparer une tension de sortie provenant directement du convertisseur numérique-analogique (20) avec une tension mémorisée sur le second filtre de boucle, après une opération de verrouillage de la seconde boucle à verrouillage de phase sur une fréquence de sortie déterminée, afin d'ajuster automatiquement le gain du convertisseur numérique-analogique.

9. Synthétiseur de fréquence (1) selon la revendication 8, **caractérisé en ce qu'**il comprend une logique de commande (22) dans l'accès haute fréquence pour recevoir un signal de sortie du comparateur de tension (21) afin de fournir un mot binaire d'ajustement du gain au convertisseur numérique-analogique (20), le mot binaire pouvant être un mot de 5 bits.

10. Synthétiseur de fréquence (1) selon l'une des revendications 8 et 9, **caractérisé en ce qu'**il comprend un suiveur de tension unitaire (6) dans la première boucle à verrouillage de phase, dont une entrée est reliée à une entrée du premier filtre de boucle, et une sortie du suiveur de tension est susceptible d'être reliée à la première entrée de l'oscillateur commandé en tension, ledit suiveur de tension unitaire étant prévu pour compenser la fuite de courant au niveau du varacteur de l'oscillateur commandé en tension.

11. Synthétiseur de fréquence (1) selon la revendication 10, **caractérisé en ce qu'**il comprend un premier multiplexeur (7) disposé entre la première entrée de l'oscillateur commandé en tension (10) et la sortie du premier filtre de boucle (5) et du suiveur de tension unitaire (6), le premier multiplexeur étant commandé pour relier le suiveur de tension ou le premier filtre de boucle à la première entrée de l'oscillateur commandé en tension.

12. Synthétiseur de fréquence (1) selon l'une des revendications 8 à 11, **caractérisé en ce qu'**il comprend un second multiplexeur (17) disposé entre la seconde entrée de l'oscillateur commandé en tension (10), dont la seconde sensibilité est de l'ordre de 100 fois inférieure à la première sensibilité de la première entrée, notamment de l'ordre de 4 MHz/V, et une sortie du second filtre de boucle (15) et d'un filtre passe-bas anti-repliement (25) relié au convertisseur numérique-analogique (20), le second multiplexeur étant commandé pour relier le filtre anti-repliement ou le second filtre de boucle à la seconde entrée de l'oscillateur commandé en tension.

13. Synthétiseur de fréquence (1) selon l'une des revendications 8 et 10, **caractérisé en ce que** la première boucle à verrouillage de phase comprend une structure différentielle composée d'une première pompe de charges différentielle, d'un premier filtre de boucle différentiel et d'un suiveur de tension différentiel pour relier soit la sortie du suiveur de tension différentiel, soit la sortie du premier filtre de boucle à la première entrée différentielle de l'oscillateur commandé en tension.

14. Synthétiseur de fréquence (1) selon la revendication 8, **caractérisé en ce que** la seconde boucle à verrouillage de phase comprend une structure différentielle composée d'une seconde pompe de charges différentielle et d'un second filtre de boucle différentiel, la sortie du second filtre de boucle étant destinée à être reliée à la seconde entrée différentielle de l'oscillateur commandé en tension lorsque la seconde boucle à verrouillage de phase est fermée.

15. Synthétiseur de fréquence (1) selon l'une des revendications 8 à 14, **caractérisé en ce qu'**il comprend un multiplexeur de modulation (27) pour fournir au moins un mot de commande d'une fréquence de modulation au convertisseur numérique-analogique (20) et à un modulateur sigma delta pour commander le compteur diviseur multi-mode de la première ou seconde boucle à verrouillage de phase, et **en ce que** le convertisseur numérique-analogique (20) est composé de sources de courant commutées et d'une charge active en poly-résistance OTA.

## Claims

1. Self-calibration method for a frequency synthesizer (1) that can perform two point frequency modulation for data transmission, the frequency synthesizer including:
- a first low frequency phase lock loop in which there are placed a reference oscillator (2), a phase comparator (3) connected to the reference oscillator, a first, low-pass loop filter (5), a voltage-controlled oscillator (10), which is connected via a first input of a first varactor with a first sensitivity in the first low frequency loop for receiving a first control voltage signal (KVCO) via the first low-pass filter, a multimode counter-divider (9) controlled by a modulator (11) to frequency divide a high frequency output signal (S_{OUT}) on the basis of a high frequency signal produced by the voltage-controlled oscillator, so as to supply a divided signal for comparison with a reference signal of the reference oscillator in the phase comparator, and
- a high frequency access in which is placed a digital-analogue converter (20) for supplying a second control voltage signal (KVCO_mod) to a second input of a second varactor with a second sensitivity of the voltage-controlled oscillator (10) for high frequency data modulation, the second sensitivity being several orders of magnitude less than the first sensitivity, and the second varactor being independent of the first varactor,
the self-calibration method including the steps of:
a) in a first phase, locking the first low-pass phase lock loop onto a transmission channel with a determined carrier frequency (fₒ) at the synthesizer output, and supplying a first command word (0, com) to the converter in the high frequency access corresponding to the determined carrier frequency for generating a second control voltage signal for the voltage-controlled oscillator, at a first basic voltage level,
b) in a second phase, opening the first phase lock loop, while maintaining, via the first loop filter, a first control voltage signal corresponding to the determined carrier frequency for the first input of the voltage-controlled oscillator, locking a second phase lock loop, which includes a second low-pass loop filter (15) in the high frequency access connected between the phase comparator (3) of the first loop and the second input of the voltage-controlled oscillator, at a first output frequency (f₀+Δf) equal to the carrier frequency added to a maximum modulation frequency shift, and supplying the digital-analogue converter with a second command word (Max, com) that represents the first output frequency (f₀+Δf),
c) in a third phase, opening the second phase lock loop while maintaining, via the second loop filter, a second control voltage signal corresponding to the first output frequency (f₀+Δf) for the second input of the voltage-controlled oscillator, and comparing an output voltage coming directly from the converter with the voltage stored in the second loop filter to calibrate the converter gain automatically so that the converter output voltage is equivalent to the voltage stored in the second filter at a second voltage level, whose shift with the first basic voltage level defines the maximum equalised modulation frequency shift, and
d) in a modulation phase, closing the first phase lock loop and connecting the converter output to the second input of the voltage-controlled oscillator for two point data modulation by the voltage-controlled oscillator using a series of command words (30, 31) in time supplied to the calibrated digital-analogue converter and to the modulator of the first phase lock loop.

2. Self-calibration method according to claim 1, **characterized in that**, between step c) and step d), it includes the steps of:
- in a fourth phase, closing and locking the second phase lock loop onto a second output frequency (f₀-Δf) which is the result of subtracting the maximum modulation frequency deviation from the carrier frequency, and supplying a third command word (Min, com) to the digital-analogue converter (20) to represent the second output frequency, and
- in a fifth phase, opening the second phase lock loop while maintaining, via the second loop filter, a second control voltage signal corresponding to the second output frequency (f₀-Δf) for the second input of the voltage-controlled oscillator, and comparing the converter output voltage to the voltage stored in the second loop filter, to calibrate the converter gain automatically so that the converter output voltage is equivalent to the voltage stored in the second filter at a third voltage level, whose shift with the first basic voltage level defines the maximum equalised modulation frequency shift.

3. Self-calibration method according to any of the preceding claims, wherein the first phase lock loop includes a first charge pump (4) between the phase comparator (3) and the first loop filter (5), and the second phase lock loop includes a second charge pump (14) between the phase comparator (3) and the second loop filter (15), **characterized in that** the first phase lock loop is opened or closed via the first charge pump, **in that** the second phase lock loop is opened or closed via the second charge pump, and **in that** during an opening phase, the first charge pump and/or the second charge pump are gradually disconnected, particularly after 60 cycles, where the bandwidth of the first and/or second phase lock loops is gradually and continually reduced to 0 Hz, to maintain a constant voltage in the first filter and/or the second filter at a well defined level.

4. Self-calibration method according to any of the preceding claims, **characterized in that** in the first to fifth phases, the first control voltage signal is supplied by a unitary voltage follower (6) connected at input to the first loop filter to compensate for the leakage current in the first varactor of the voltage-controlled oscillator.

5. Self-calibration method according to claim 4, wherein a first multiplexer (7) is arranged between the first input of the voltage-controlled oscillator (10) and the output of the first loop filter (5) and the unitary voltage follower (6), **characterized in that** in the first to fifth phases, the first multiplexer (7) is controlled to connect the voltage follower to the first input of the voltage-controlled oscillator, whereas in the modulation phase, the first multiplexer is controlled to connect the first low-pass filter to the first input of the voltage-controlled oscillator.

6. Self-calibration method according to any of the preceding claims, wherein a second multiplexer (17) is arranged between the second input of the voltage-controlled oscillator and an output of the second loop filter (15) and a low-pass anti-aliasing filter (25) connected to the digital-analogue converter (20), **characterized in that** in the first phase and the modulation phase, the second multiplexer (17) is controlled to connect the second input of the voltage-controlled oscillator to the anti-aliasing filter (25) for direct supplying the second control voltage signal originating from the digital-analogue converter (20) output, and **in that** in the second to fifth phases, the second multiplexer is controlled to connect the second input of the voltage-controlled oscillator to the second loop filter to receive a third control voltage signal.

7. Self-calibration method according to any of the preceding claims, **characterized in that** the digital-analogue converter calibration steps are performed as soon as the synthesizer is switched on or in a synthesizer operating mode at the end of each programmed operating period, and **in that** a control logic (22), connected at output to a comparator (21), adapts the converter gain by a binary word, such as a 5-bit word.

8. Frequency synthesizer (1) for implementing the self-calibration method according to any of the preceding claims, the frequency synthesizer being able to perform two point frequency modulation for data transmission, said frequency synthesizer including:
- a first low frequency phase lock loop in which there are placed a reference oscillator (2), a phase comparator (3) connected to the reference oscillator, a first low-pass loop filter (5) connected to the phase comparator via a first charge pump (4), a voltage-controlled oscillator (10), which is connected via a first input of a first varactor with a first sensitivity in the first low frequency loop for receiving a first control voltage signal (KVCO) via the first low-pass filter, a multimode counter-divider (9) controlled by a modulator (11) to frequency divide a high frequency output signal (S_{OUT}) on the basis of a high frequency signal produced by the voltage-controlled oscillator, so as to supply a divided signal for comparison with a reference signal of the reference oscillator in the phase comparator, and
- a high frequency access in which is placed a digital-analogue converter (20) for supplying a second control voltage signal (KVCO_mod) to a second input of a second varactor with a second sensitivity of the voltage-controlled oscillator (10) for high frequency data modulation, the second sensitivity being several orders of magnitude less than the first sensitivity, and the second varactor being independent of the first varactor,
the frequency synthesizer including a second loop filter (15) in the high frequency access that can be connected via a second charge pump (14) between the phase comparator (3) of the first loop and the second input of the voltage-controlled oscillator (10) so as to form a second low frequency phase lock loop for a digital-analogue converter calibration operation, and in that the high frequency access includes a voltage comparator (21) for comparing an output voltage, which comes directly from the digital-analogue converter (20), to a voltage stored in the second loop filter, after locking the second phase lock loop onto a determined output frequency, so as to automatically adjust the digital-analogue converter gain.

9. Frequency synthesizer (1) according to claim 8, **characterized in that** it includes a control logic (22) in the high frequency access for receiving an output signal from the voltage comparator (21) so as to supply a binary word for adjusting the digital-analogue converter (20) gain, where the binary word can be a 5-bit word.

10. Frequency synthesizer (1) according to any of claims 8 and 9, **characterized in that** it includes a unitary voltage follower (6) in the first phase lock loop, one input of which is connected to one input of the first loop filter, and one output of the voltage follower can be connected to a first input of the voltage-controlled oscillator, said unitary voltage follower being provided to compensate for any current leakage in the voltage-controlled oscillator varactor.

11. Frequency synthesizer (1) according to claim 10, **characterized in that** it includes a first multiplexer (7) arranged between the first input of the voltage-controlled oscillator (10) and the output of the first loop filter (5) and the unitary voltage follower (6), the first multiplexer being controlled to connect the voltage follower or the first loop filter to the first input of the voltage-controlled oscillator.

12. Frequency synthesizer (1) according to any of claims 8 to 11, **characterized in that** it includes a second multiplexer (17) arranged between the second input of the voltage-controlled oscillator (10), the second sensitivity of which is of the order of 100 times less than the first sensitivity of the first input, in particular around 4 MHz/V, and one output of the second loop filter (15) and a low-pass anti-aliasing filter (25) connected to the digital-analogue converter (20), the second multiplexer being controlled to connect the anti-aliasing filter or the second loop filter to the second input of the voltage-controlled oscillator.

13. Frequency synthesizer (1) according to any of claims 8 and 10, **characterized in that** the first phase lock loop includes a differential structure formed of a first differential charge pump, a first differential loop filter and a differential voltage follower for connecting either the output of the differential voltage follower, or the output of the first loop filter to the first differential input of the voltage-controlled oscillator.

14. Frequency synthesizer (1) according to claim 8, **characterized in that** the second phase lock loop includes a differential structure formed of a second differential charge pump and a second differential loop filter, wherein the output of the second loop filter is for connection to the second differential input of the voltage-controlled oscillator when the second phase lock loop is closed.

15. Frequency synthesizer (1) according to any of claims 8 to 14, **characterized in that** it includes a modulation multiplexer (27) for supplying at least one modulation frequency command word to the digital-analogue converter (20) and to a sigma delta modulator for controlling the multimode counter-divider of the first or second phase lock loop, and **in that** the digital-analogue converter (20) is formed of switched current sources and an active poly-resistance load OTA.

## Patentansprüche

1. Verfahren zum Autokalibrieren eines Frequenzsynthetisierers (1), der eine Frequenzmodulation an zwei Punkten für die Datenübertragung ausführen kann, wobei der Frequenzsynthetisierer umfasst:
- eine erste Verriegelungsschleife mit Niederfrequenzphase, in der ein Referenzoszillator (2), ein Phasenkomparator (3), der mit dem Referenzoszillator verbunden ist, ein erstes Tiefpass-Schleifenfilter (5), ein spannungsgesteuerter Oszillator (10), der über einen ersten Eingang mit einem ersten Varaktor mit einer ersten Empfindlichkeit in der ersten Niederfrequenzschleife verbunden ist, um ein erstes Steuerspannungssignal (KVCO) über das erste Tiefpassfilter zu empfangen, und ein Multimodenteiler-Zähler (9), der durch einen Modulator (11) gesteuert wird, um eine Frequenzteilung eines Hochfrequenz-Ausgangssignals (S_{OUT}) auf der Basis eines von dem spannungsgesteuerten Oszillator erzeugten Hoch-frequenzsignals auszuführen, um ein geteiltes Signal zu liefern, das mit einem Referenzsignal des Referenzoszillators in dem Phasenkomparator zu vergleichen ist, angeordnet sind, und
- einen Hochfrequenzzugang, in dem ein Digital/Analog-Umsetzer (20) angeordnet ist, um ein zweites Steuerspannungssignal (KVCO_mod) zu einem zweiten Eingang eines zweiten Varaktors mit einer zweiten Empfindlichkeit des spannungsgesteuerten Oszillators (10) zu liefern, um Hochfrequenzdaten zu modulieren, wobei die zweite Empfindlichkeit um mehrere Größenordnungen kleiner ist als die erste Empfindlichkeit und wobei der zweite Varaktor von dem ersten Varaktor unabhängig ist,
wobei das Autokalibrierungsverfahren die folgenden Schritte umfasst:
a) in einer ersten Phase Verriegeln der ersten Tiefpass-Phasenverriegelungsschleife auf einem Übertragungskanal auf eine bestimmte Trägerfrequenz (f₀) am Ausgang des Synthetisierers und Liefern eines ersten Steuerworts (0, com) zu dem Umsetzer im Hochfrequenzzugang, das der bestimmten Trägerfrequenz entspricht, um ein zweites Steuerspannungssignal für den spannungsgesteuerten Oszillator mit einem ersten Basisspannungspegel zu erzeugen,
b) in einer zweiten Phase Öffnen der ersten Phasenverriegelungsschleife und dabei Halten des ersten Steuerspannungssignals, das der bestimmten Trägerfrequenz entspricht, durch das erste Schleifenfilter für den ersten Eingang des spannungsgesteuerten Oszillators, Verriegeln einer zweiten Phasenverriegelungsschleife, die ein zweites Tiefpassfilter (15) enthält, im Hochfrequenzzugang, das zwischen den Phasenkomparator (3) der ersten Schleife und den zweiten Eingang des spannungsgesteuerten Oszillators geschaltet ist, auf eine erste Ausgangsfrequenz (f₀ + Δf), die gleich der um einen maximalen Modulationsfrequenzabstand erhöhten Trägerfrequenz ist, und Liefern eines zweiten Steuerworts (Max, com) zu dem Digital/Analog-Umsetzer, um die erste Ausgangs-frequenz (f₀ + Δf) darzustellen,
c) in einer dritten Phase Öffnen der zweiten Phasenverriegelungsschleife und dabei Halten eines zweiten Steuerspannungssignals, das der ersten Ausgangsfrequenz (f₀ + Δf) entspricht, durch das zweite Schleifenfilter für den zweiten Eingang des spannungsgesteuerten Oszillators und Vergleichen einer Ausgangsspannung, die direkt vom Umsetzer stammt, mit der im zweiten Schleifenfilter gespeicherten Spannung, um die Verstärkung des Umsetzers automatisch zu kalibrieren, damit die Ausgangsspannung des Umsetzers zu der im zweiten Filter gespeicherten Spannung mit einem zweiten Spannungspegel, dessen Abstand zum ersten Basisspannungspegel den abgeglichenen maximalen Modulations-Frequenzabstand definiert, äquivalent ist, und
d) in einer Modulationsphase Schließen der ersten Phasenverriegelungsschleife und Verbinden des Ausgangs des Umsetzers mit dem zweiten Eingang des spannungsgesteuerten Oszillators, um Daten an zwei Punkten durch den spannungsgesteuerten Oszillator mit Hilfe einer zeitlichen Folge von Steuerwörtern (30, 31) zu modulieren, die an den kalibrierten Digital/Analog-Umsetzer und an den Modulator der ersten Phasenverriegelungsschleife geliefert werden.

2. Autokalibrierungsverfahren nach Anspruch 1, **dadurch gekennzeichnet, dass** es zwischen dem Schritt c) und dem Schritt d) die folgenden Schritte umfasst:
- in einer vierten Phase Schließen und Verriegeln der zweiten Phasenverriegelungsschleife auf einer zweiten Ausgangsfrequenz (f₀ - Δf), die gleich der um den maximalen Modulationsfrequenzabstand verringerten Trägerfrequenz ist, und Liefern eines dritten Steuerworts (Min, com) zu dem Digital/Analog-Umsetzer (20), um die zweite Ausgangsfrequenz darzustellen, und
- in einer fünften Phase Öffnen der zweiten Phasenverriegelungsschleife und dabei Halten eines zweiten Steuerspannungssignals, das der zweiten Ausgangsfrequenz (f₀ - Δf) entspricht, für den zweiten Eingang des spannungsgesteuerten Oszillators durch das zweite Schleifenfilter und Vergleichen der Ausgangsspannung des Umsetzers mit der im zweiten Schleifenfilter gespeicherten Spannung, um die Verstärkung des Umsetzers automatisch zu kalibrieren, damit die Ausgangsspannung des Umsetzers zu der im zweiten Filter gespeicherten Spannung, die einen dritten Spannungspegel besitzt, dessen Abstand zum ersten Pegel der Basisspannung den abgeglichenen maximalen Modulationsfrequenz-abstand definiert, äquivalent ist.

3. Autokalibrierungsverfahren nach einem der vorhergehenden Ansprüche, wobei die erste Phasenverriegelungsschleife eine erste Ladungspumpe (4) zwischen dem Phasenkomparator (3) und dem ersten Schleifenfilter (5) enthält und die zweite Phasenverriegelungsschleife eine zweite Ladungspumpe (14) zwischen dem Phasenkomparator (3) und dem zweiten Schleifenfilter (15) enthält, **dadurch gekennzeichnet, dass** das Öffnen oder das Schließen der ersten Phasenverriegelungsschleife über die erste Ladungspumpe ausgeführt wird, dass das Öffnen oder das Schließen der zweiten Phasenverriegelungsschleife über die zweite Ladungspumpe ausgeführt wird und dass während einer Öffnungsphase die erste Ladungspumpe und/oder die zweite Ladungspumpe allmählich getrennt werden, insbesondere nach 60 Zyklen, wo die Bandbreite der ersten und/oder der zweiten Phasenverriegelungsschleife allmählich und ununterbrochen auf 0 Hz verringert wird, um eine konstante Spannung am ersten Filter und/oder am zweiten Filter mit einem genau bestimmten Pegel zu halten.

4. Autokalibrierungsverfahren nach einem der vorhergehenden Ansprüche, **dadurch gekennzeichnet, dass** in der ersten bis fünften Phase das erste Steuerspannungssignal durch einen Einheitsspannungsfolger (6) geliefert wird, der mit seinem Eingang mit dem ersten Schleifenfilter verbunden ist, um den Stromverlust auf Höhe des ersten Varaktors des spannungsgesteuerten Oszillators auszugleichen.

5. Autokalibrierungsverfahren nach Anspruch 4, wobei ein erster Multiplexer (7) zwischen dem ersten Eingang des spannungsgesteuerten Oszillators (10) und dem Ausgang des ersten Schleifenfilters (5) und des Einheitsspannungsfolgers (6) angeordnet ist, **dadurch gekennzeichnet, dass** in der ersten bis fünften Phase der erste Multiplexer (7) gesteuert wird, um den Spannungsfolger mit dem ersten Eingang des spannungsgesteuerten Oszillators zu verbinden, während in der Modulationsphase der erste Multiplexer gesteuert wird, um das erste Tiefpassfilter mit dem ersten Eingang des spannungsgesteuerten Oszillators zu verbinden.

6. Autokalibrierungsverfahren nach einem der vorhergehenden Ansprüche, wobei der zweite Multiplexer (17) zwischen dem zweiten Eingang des spannungsgesteuerten Oszillators und einem Ausgang des zweiten Schleifenfilters (15) und eines Kippverhinderungs-Tiefpassfilters (25), das mit dem Digital/Analog-Umsetzer (20) verbunden ist, angeordnet ist, **dadurch gekennzeichnet, dass** in der ersten Phase und in der Modulationsphase der zweite Multiplexer (17) gesteuert wird, um den zweiten Eingang des spannungsgesteuerten Oszillators mit dem Kippverhinderungsfilter (25) zu verbinden, um das zweite Steuerspannungssignal, das vom Ausgang des Digital/Analog-Umsetzers (20) stammt, direkt zu liefern, und dass in der zweiten bis fünften Phase der zweite Multiplexer gesteuert wird, um den zweiten Eingang des spannungsgesteuerten Oszillators mit dem zweiten Schleifenfilter zu verbinden, um ein drittes Steuerspannungssignal zu empfangen.

7. Autokalibrierungsverfahren nach einem der vorhergehenden Ansprüche, **dadurch gekennzeichnet, dass** die Kalibrierungsschritte des Digital/Analog-Umsetzers ausgeführt werden, sobald der Synthetisierer in Betrieb genommen worden ist, oder in einer Betriebsart des Synthetisierers am Ende jeder programmierten Betriebsperiode ausgeführt werden, und dass eine Steuerlogik (22), die mit dem Ausgang eines Komparators (21) verbunden ist, die Verstärkung des Umsetzers durch ein Binärwort wie etwa ein Wort aus 5 Bits anpasst.

8. Frequenzsynthetisierer (1) für die Ausführung des Autokalibrierungsverfahrens nach einem der vorhergehenden Ansprüche, **dadurch gekennzeichnet, dass** der Frequenzsynthetisierer eine Frequenzmodulation an zwei Punkten für die Datenübertragung ausführen kann, wobei der Frequenzsynthetisierer umfasst:
- eine erste Niederfrequenz-Phasenverriegelungsschleife, in der ein Referenzoszillator (2), ein Phasenkomparator (3), der mit dem Referenzoszillator verbunden ist, ein erstes Tiefpassschleifenfilter (5), das mit dem Phasenkomparator über eine erste Ladungspumpe (4) verbunden ist, ein spannungsgesteuerter Oszillator (10), der über einen ersten Eingang eines ersten Varaktors mit einer ersten Empfindlichkeit in der ersten Niederfrequenzschleife verbunden ist, um ein erstes Steuerspannungssignal (KVCO) über das erste Tiefpassfilter zu empfangen, und ein Multimodenteiler-Zähler (9), der durch einen Modulator (11) gesteuert wird, um eine Frequenzteilung eines Hochfrequenz-Ausgangssignals (S_{OUT}) an der Basis eines durch den spannungsgesteuerten Oszillator erzeugten Hochfrequenzsignals auszuführen, um ein geteiltes Signal, das mit einem Referenzsignal des Referenzoszillators in dem Phasenkomparator zu vergleichen ist, zu liefern, angeordnet sind, und
- einen Hochfrequenzzugang, in dem ein Digital/Analog-Umsetzer (20) angeordnet ist, um ein zweites Steuerspannungssignal (KVCO_mod) an einen zweiten Eingang eines zweiten Varaktors mit einer zweiten Empfindlichkeit des spannungsgesteuerten Oszillators (10) zu liefern, um Hochfrequenzdaten zu modulieren, wobei die zweite Empfindlichkeit um mehrere Größenordnungen kleiner ist als die erste Empfindlichkeit und wobei der zweite Varaktor von dem ersten Varaktor unabhängig ist,
wobei der Frequenzsynthetisierer ein zweites Schleifenfilter (15) im Hochfrequenzzugang enthält, das über eine zweite Ladungspumpe (14) zwischen den Phasenkomparator (3) der ersten Schleife und den zweiten Eingang des spannungsgesteuerten Oszillators (10) geschaltet werden kann, um eine zweite Niederfrequenz-Phasenverriegelungsschleife für eine Kalibrierungsoperation des Digital/Analog-Umsetzers zu bilden, und dass der Hochfrequenzzugang einen Spannungskomparator (21) umfasst, um eine Ausgangsspannung, die direkt von dem Digital/Analog-Umsetzer (20) stammt, mit einer im zweiten Schleifenfilter gespeicherten Spannung zu vergleichen, nachdem eine Verriegelungsoperation der zweiten Phasenverriegelungsschleife bei einer bestimmten Ausgangsfrequenz erfolgt ist, um die Verstärkung des Digital/Analog-Umsetzers automatisch einzustellen.

9. Frequenzsynthetisierer (1) nach Anspruch 8, **dadurch gekennzeichnet, dass** er eine Steuerlogik (22) im Hochfrequenzzugang aufweist, um ein Ausgangssignal des Spannungsgenerators (21) zu empfangen, um ein Binärwort für die Einstellung der Verstärkung des Digital/Analog-Umsetzers (20) zu liefern, wobei das Binärwort ein Wort aus 5 Bits sein kann.

10. Frequenzsynthetisierer (1) nach einem der Ansprüche 8 und 9, **dadurch gekennzeichnet, dass** er einen Einheitsspannungsfolger (6) in der ersten Phasenverriegelungsschleife umfasst, dessen Eingang mit einem Eingang des ersten Schleifenfilters verbunden ist, wobei ein Ausgang des Spannungsfolgers mit dem ersten Eingang des spannungsgesteuerten Oszillators verbunden werden kann, wobei der Einheitsspannungsfolger vorgesehen ist, um den Stromverlust auf Höhe des Varaktors des spannungsgesteuerten Oszillators auszugleichen.

11. Frequenzsynthetisierer (1) nach Anspruch 10, **dadurch gekennzeichnet, dass** er einen ersten Multiplexer (7) umfasst, der zwischen dem ersten Eingang des spannungsgesteuerten Oszillators (10) und dem Ausgang des ersten Schleifenfilters (5) und des Einheitsspannungsfolgers (6) angeordnet ist, wobei der erste Multiplexer gesteuert wird, um den Spannungsfolger oder das erste Schleifenfilter mit dem ersten Eingang des spannungsgesteuerten Oszillators zu ver-binden.

12. Frequenzsynthetisierer (1) nach einem der Ansprüche 8 bis 11, **dadurch gekennzeichnet, dass** er einen zweiten Multiplexer (17) umfasst, der zwischen dem zweiten Eingang des spannungsgesteuerten Oszillators (10), dessen zweite Empfindlichkeit in einer Größenordnung liegt, die hundertmal kleiner ist als die erste Empfindlichkeit des ersten Eingangs, insbesondere in der Größenordnung von 4 MHz/V und einem Ausgang des zweiten Schleifenfilters (15) und eines Kippverhinderungs-Tiefpassfilters (25), das mit dem Digital/Analog-Umsetzer (20) verbunden ist, angeordnet ist, wobei der zweite Multiplexer gesteuert wird, um das Kippverhinderungsfilter oder das zweite Schleifenfilter mit dem zweiten Eingang des spannungsgesteuerten Oszillators zu verbinden.

13. Frequenzsynthetisierer (1) nach einem der Ansprüche 8 bis 10, **dadurch gekennzeichnet, dass** die erste Phasenverriegelungsschleife eine differentielle Struktur aufweist, die aus einer ersten differentiellen Ladungspumpe, einem ersten differentiellen Schleifenfilter und einem ersten differentiellen Spannungsfolger gebildet ist, um entweder den Ausgang des differentiellen Spannungsfolgers oder den Ausgang des ersten Schleifenfilters mit dem ersten differentiellen Eingang des spannungsgesteuerten Oszillators zu verbinden.

14. Frequenzsynthetisierer (1) nach Anspruch 8, **dadurch gekennzeichnet, dass** die zweite Phasenverriegelungsschleife eine differentielle Struktur aufweist, die aus einer zweiten differentiellen Ladungspumpe und einem zweiten differentiellen Schleifenfilter gebildet ist, wobei der Ausgang des zweiten Schleifenfilters dazu vorgesehen ist, mit dem zweiten differentiellen Eingang des spannungs-gesteuerten Oszillators verbunden zu werden, wenn die zweite Phasenverriegelungsschleife geschlossen ist.

15. Frequenzsynthetisierer (1) nach einem der Ansprüche 8 bis 14, **dadurch gekennzeichnet, dass** er einen Modulationsmultiplexer (27) umfasst, um wenigstens ein Steuerwort mit einer Modulationsfrequenz zu dem Digital/Analog-Umsetzer (20) und zu einem Sigma/Delta-Modulator zu liefern, um den Multimodenteiler-Zähler der ersten oder der zweiten Phasenverriegelungsschleife zu steuern, und dass der Digital/Analog-Umsetzer (20) aus geschalteten Stromquellen und aus einer aktiven Last mit einem Polywiderstand OTA aufgebaut ist.
